(19) Europäisches Patentamt
European Patent Office
Office européen des brevets

(11) EP 2 724 854 A1

(12) **EUROPEAN PATENT APPLICATION**
published in accordance with Art. 153(4) EPC

(43) Date of publication:
**30.04.2014 Bulletin 2014/18**

(21) Application number: **12805138.0**

(22) Date of filing: **13.06.2012**

(51) Int Cl.:
***B32B 9/00*** *(2006.01)* ***B05D 1/38*** *(2006.01)*
***B05D 3/06*** *(2006.01)* ***B05D 7/24*** *(2006.01)*
***B32B 5/14*** *(2006.01)* ***B32B 27/00*** *(2006.01)*
***B32B 27/16*** *(2006.01)* ***H01L 51/50*** *(2006.01)*
***H05B 33/04*** *(2006.01)*

(86) International application number:
**PCT/JP2012/065097**

(87) International publication number:
**WO 2013/002026 (03.01.2013 Gazette 2013/01)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **27.06.2011 JP 2011141490**

(71) Applicant: **Konica Minolta, Inc.**
**Tokyo 100-7015 (JP)**

(72) Inventor: **MORI, Takahiro**
**Hachioji-shi**
**Tokyo 192-8505 (JP)**

(74) Representative: **Green, Mark Charles**
**Urquhart-Dykes & Lord LLP**
**The Podium**
**1 Eversholt Street**
**London NW1 2DN (GB)**

# (54) GAS BARRIER FILM, MANUFACTURING PROCESS FOR GAS BARRIER FILM, AND ELECTRONIC DEVICE

(57) Provided are a gas barrier film which has extremely excellent gas barrier performance and high durability, a manufacturing method thereof, and an electronic device using the same. The gas barrier film having at least two gas barrier layers which contain at least Si, O and N and are laminated on a substrate, in which the total thicknesswise composition distribution of the gas barrier layers includes both a thicknesswise continuous region which has a thickness of 20 nm or more and satisfies the following composition range (A) and a thicknesswise continuous region which has a thickness of 50 nm or more and satisfies the following composition range (B) in this order from the substrate side. (A): when the composition of the gas barrier layer is represented by SiOwNx, $w \geq 0.8$, $x \geq 0.3$, and $2w + 3x \leq 4$, and (B): when the composition of the gas barrier layer is represented by SiOyNz, $0 < y \leq 0.55$ and $z \geq 0.55$, and $2y + 3z \leq 4$.

FIG. 1

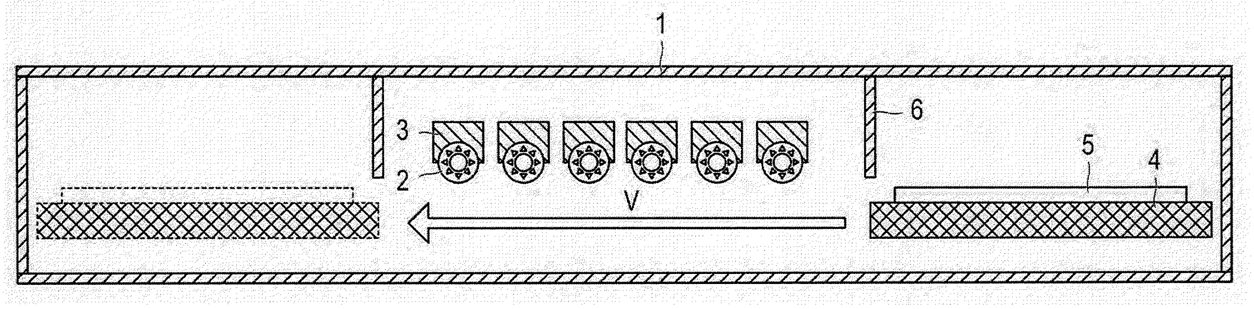




Printed by Jouve, 75001 PARIS (FR)

## Description

### TECHNICAL FIELD

The present invention relates to a gas barrier film, amanufacturingmethod for a gas barrier film, and an electronic device. More specifically, it relates to a gas barrier film which is mainly used for an electronic device such as an organic electroluminescence (EL) element, a solar cell element, or a liquid crystal display element, a manufacturing method thereof, and an electronic device using it.

### BACKGROUND ART

Conventionally, a gas barrier film produced by laminating plural layers including a thin film of metallic oxide such as aluminum oxide, magnesium oxide, or silicon oxide on the surface of a plastic substrate or a film has been extensively used to package the products that require blocking of various types of gases such as water vapor and oxygen, for example, for packaging purposes to package the foods, industrial products, and pharmaceutical products to prevent them from being deteriorated.

In addition to packaging purposes, development into a flexible electronic device such as a solar cell element, an organic electroluminescence (EL) element, or a liquid crystal display element having flexibility is required, and thus various studies are made. However, since those flexible electronic devices are required to have a gas barrier property or durability that is at the same high level as a glass substrate, in the present moment, a gas barrier film with satisfying performance has not been obtained yet.

As a method for producing those gas barrier films, a gas phase method as follows is known: a chemical vapor depositionmethod (CVDmethod) for forming a filmon a substrate with oxidation using oxygen plasma under reduced pressure by using an organosilicon compound represented by tetraethoxyosilane (TEOS), and a physical vapor deposition method (vacuum vapor deposition or sputtering method) including evaporating metal Si by using a semiconductor laser and depositing it on a substrate in the presence of oxygen.

Since a thin film having accurate composition can be formed on a substrate, an inorganic film forming method based on those gas phase methods has been preferably applied for forming an inorganic film such as silicon oxide, silicon nitride, or silicon oxynitride.

A silicon nitride film is particularly known to have a good barrier property. However, as it has poor transparency, studies have been made to obtain a silicon oxynitride film having both the gas barrier property and transparency for commercialization, and various studies are also made regarding a desirable composition range.

For example, in Patent Literature 1, a silicon oxynitride layer having x/y ratio in the range of 0.55 to 4.0, in which composition of the silicon oxynitride layer formed by sputtering is expressed as $SiO_xN_y$, is disclosed. Although it is described that stable film quality can be achieved by having the x/y ratio within the above range, the composition range is very broad and there is a huge deviation in the performance. Further, even it is controlled to the above composition range, a sufficient barrier property cannot be obtained.

In Patent Literature 2, a film consisting of two silicon oxynitride layers formed by sputtering, in which an element concentration ratio of O/(O+N) in a lower silicon oxynitride layer is smaller than an element concentration ratio of O/(O + N) in an upper silicon oxynitride layer, is disclosed, and it is described that the lower layer and the upper layer have the composition range of $0 < O/(O + N) \leq 0.4$ and $0.3 < O/(O + N) < 1$, respectively. It is described that, according to the above definitions, by having a nitrogen-rich dense layer as a lower layer and suppressing outgas from a surface layer of the substrate during vacuum film formation of an upper layer, a film favored as an upper layer is obtained, and as a result, both the transparency and gas barrier property of a film can be obtained. However, since the composition range is very broad and also there is an overlapping region in the preferred composition range between the lower layer and the upper layer, it is difficult to say that a composition range for exhibiting a favorable gas barrier property is specified.

In Patent Literature 3, a film consisting of two inorganic layers that are formed by sputtering or ion plating, in which the lower layer is a thin layer having composition of $SiO_w$ and the upper layer is a $SiO_xN_y$ layer thicker than the lower layer, and the preferred composition range of the upper layer is $130 \leq x + y \leq 180$, $10 \leq x \leq 135$, and also $5 \leq y \leq 150$ when Si = 100, is disclosed. It is described that in-plain uniformity of the barrier layer is enhanced by having such constitution. However, since the defined composition range of the upper layer as a main barrier layer is broad, it is difficult to say that a composition range for exhibiting a favorable gas barrier property is specified.

In Patent Literature 4, a film consisting of three inorganic layers formed by CVD, in which a gas barrier layer has a silicon nitride layer, a silicon oxynitride layer, and a silicon nitride layer in this order from a substrate side and the preferred composition ratio is $r = (2x + 3y)$ and $3.15 \leq r \leq 4.0$ when the composition of the silicon oxynitride layer is $SiO_xN_y$, is disclosed. It is describedthat the transparency, gas barrier property, and flexibility are obtained by having such constitution. However, since the defined composition range of the silicon oxynitride layer is broad, it is difficult to say that a composition range for exhibiting a favorable gas barrier property is specified.

As described above, although various studies have been made regarding a composition range of a silicon oxynitride layer for obtaining a favorable gas barrier property and also regarding a layer configuration containing a silicon oxynitride layer, specifying the composition range or layer configuration for having particularly favorable gas barrier property has not been achieved yet.

Further, even when a silicon oxynitride layer having a specific composition range is formed by a film formation method based on a gas phase method described above, it is extremely difficult to form a defect-free film by a vapor phase method. For example, since it is necessary to inhibit generation of defects by lowering a film formation rate to an extreme level, a gas barrier property necessary for a flexible electronic device is not obtained at an industrial level requiring productivity. Although studies are also made to simply increase film thickness of an inorganic film by a vapor phase method or laminate plural layers of an inorganic layer, defects tend to continuously grow or more cracks are generated, and thus enhancement of the gas barrier property is not obtained.

Meanwhile, studies are also made to enhance the gas barrier property by alternatively forming plural layers of an inorganic layer and an organic layer by a vapor phase method to ensure total thickness of an inorganic layer without continuously growing defects and also by enhancing a gas barrier property by increasing a gas permeation path length based on different in-plane directional position of defects in each inorganic film, that is, a so-called maze effect. However, in the present state, it cannot be said that the barrier property is sufficient, and it is also believed that commercialization is difficult in terms of cost because the processes are complicated and productivity is significantly low compared to performance.

As a method of solving the problems described above, investigations are made for enhancing the gas barrier property by modifying a coating layer, which is formed by applying and drying a solution of an inorganic precursor compound, with heat or light. In particular, investigations are also made for expressing a high gas barrier property by using polysilazane as an inorganic precursor compound.

Polysilazane is a compound having $-(SiH_2-NH)-$ as a basic structure (perhydropolysilazane is exemplified). When polysilazane is subjected to a heating treatment or a wet heat treatment under an oxidative atmosphere, via silicon oxynitride, it is transformed into silicon oxide. At that time, as direct substitution of nitrogen with oxygen occurs due to oxygen or water vapor present in an atmosphere, it is transformed into silicon nitride in a state with relatively small volume shrinkage. Accordingly, it is known that a relatively dense film having few defects in film that are caused by volume shrinkage can be obtained. By controlling the oxidizing property of an atmosphere, it is also possible to obtain a relatively dense silicon oxynitride film.

However, forming a dense silicon oxynitride film or silicon nitride film by thermal modification or wet heat modification of polysilazane requires high temperature like 450°C or higher, and thus it is not possible to apply it on a flexible substrate such as plastics.

As a means for solving those problems, a method of forming a silicon oxynitride film or a silicon nitride film by performing vacuum ultraviolet ray irradiation on a coating film formed by applying a polysilazane solution has been suggested.

By performing an oxidation reaction using active oxygen or ozone with direct cutting of atomic bonds, which is based only on an action of photons referred to as a photon process, formation of a silicon oxynitride film or a silicone oxide film can be carried out at relatively low temperature by using photo energy of 100 to 200 nm referred to as vacuum ultraviolet ray (hereinbelow, referred to as "VUV" or "VUV ray") which has higher energy than bonding force between each atom of polysilazane.

In Non-Patent Literature 1, a method of manufacturing a gas barrier film by irradiating a film coated with a polysilazane compound with VUV ray using an excimer lamp is disclosed.

**Citation List**

**Patent Literature**

Patent Literature 1: Japanese Patent Application Laid-Open No. 2002-322561
Patent Literature 2: Japanese Patent Application Laid-Open No. 2003-206361
Patent Literature 3: Japanese Patent Application Laid-Open No. 2004-314626
Patent Literature 4: US Patent Application Publication No. 2006/0226517


Non-Patent Literature


Non-Patent Literature 1: Leibniz Institute of Surface Modification Biannual Report 2008/2009: P18-P21

## SUMMARY OF INVENTION

### Technical Problem

In Non-Patent Literature 1, layer configuration or manufacturing condition is not determined in detail so that the gas barrier property of the obtained gas barrier film is far below the gas barrier property that is required for a flexible electronic device. Further, almost no determinations are made in the present state regarding which film composition of a polysilazane-modified film obtained by irradiating a polysilazane compound with VUV ray is suitable for obtaining even higher gas barrier property.

Thus, there has been a demand for a gas barrier film which has a very high barrier property and also productivity that are required for a flexible electronic device or the like.

The present invention is achieved in view of the problems described above, and an object thereof is to provide a gas barrier film having an extremely excellent gas barrier property and durability, and an electronic device using it. Another object of the present invention is to provide a manufacturing method enabling manufacture of the gas barrier film by using a coating process with excellent productivity.

### Solution to Problem

At least one of the objects of the present invention described above is achieved by the following constitution.

1. A gas barrier filmhaving at least two gas barrier layers which contain at least Si, O, and N and are laminated on a substrate, in which the total thicknesswise composition distribution of the gas barrier layers includes both a thicknesswise continuous region which has a thickness of 20 nm or more and satisfies the following composition range (A) and a thicknesswise continuous region which has a thickness of 50 nm or more and satisfies the following composition range (B) in this order from the substrate side.

   (A): When the composition of the gas barrier layer is represented by $SiO_wN_x$, $w \geq 0.8$, $x \geq 0.3$, and $2w + 3x \leq 4$.
   (B): When the composition of the gas barrier layer is represented by $SiO_yN_z$, $0 < y \leq 0.55$ and $z \geq 0.55$, and $2y + 3z \leq 4$.

2. The gas barrier film described in the above item 1, in which the thicknesswise continuous region satisfying the composition range (A) is 40 nm to 100 nm.
3. The gas barrier film described in the above item 1 or 2, in which the thicknesswise continuous region satisfying the composition range (B) is 100 nm to 1.0 μm.
4. The gas barrier film described in any one of the above items 1 to 3, in which the gas barrier layer is a layer formed by irradiating a layer containing polysilazane with vacuum ultraviolet ray.
5. An electronic device using the gas barrier film described in any one of the above items 1 to 4.
6. A method for manufacturing the gas barrier film described in any one of the above items 1 to 4 including forming the gas barrier layer by performing irradiation of vacuum ultraviolet ray on a layer formed by applying a solution containing a polysilazane compound.

According to the present invention, a gas barrier film having an extremely excellent gas barrier property and durability and an electronic device using it can be provided. Amanufacturingmethod enabling manufacture of the gas barrier film by using a coating process with excellent productivity can be also provided.

## BRIEF DESCRIPTION OF DRAWINGS

Fig. 1 is a cross-sectional schematic diagram of a vacuum ultraviolet illumination apparatus. In Fig. 1, 1 represents an apparatus chamber; 2 represents a Xe excimer lamp; 3 represents a holder of an examiner lamp, functioning also as an external electrode; 4 represents a sample stage; 5 represents a sample with layer formed thereon; and 6 represents a light shielding plate.

## DESCRIPTION OF EMBODIMENTS

Hereinbelow, embodiments for carrying out the present invention are explained in detail.

Inventors of the present invention conducted intensive studies in view of the problems described above, and as a result, found that, with a gas barrier film having at least two gas barrier layers which contain at least Si, O, and N are laminated on a substrate, in which the total thicknesswise composition distribution of the gas barrier layers includes

both a thicknesswise continuous region which has a thickness of 20 nm or more and satisfies the following composition range (A) and a thicknesswise continuous region which has a thickness of 50 nm or more and satisfies the following composition range (B) in the order from the substrate side, a gas barrier film which can be manufactured by a coating method with excellent productivity and has an extremely excellent gas barrier property can be achieved and the present invention is achieved accordingly.

(A): When the composition of the gas barrier layer is represented by SiOwNx, $w \geq 0.8$, $x \geq 0.3$, and $2w + 3x \leq 4$.
(B): When the composition of the gas barrier layer is represented by SiOyNz, $0 < y \leq 0.55$, $z \geq 0.55$, and $2y + 3z \leq 4$.

Specifically, the present invention is characterized in that, in terms of the layer configuration described above in particular, the gas barrier layer including silicon oxynitride which contains Si, O, and N has at least two regions having a thicknesswise composition range, and the SiOwNx region having the above composition range (A) is present continuously at a thickness of 20 nm or more at a side closer to the substrate and the SiOyNz region having the above composition range (B) is present continuously at a thickness of 50 nm or more at a side farther from the substrate.
When plural gas barrier layers are laminated, it is possible that a region having the composition range (A) or (B) is present continuously in neighboring regions. Specifically, the expression "SiOwNx region having the composition range (A) is present continuously at a thickness of 20 nm or more" includes both a mode in which the SiOwNx region having the composition range (A) is present continuously at a thickness of 20 nm or more in a single gas barrier layer and a mode in which the SiOwNx region having the composition range (A) is present continuously at a thickness of 20 nm or more over at least two neighboring gas barrier layers. Similarly, the expression "SiOyNz region having the composition range (B) is present continuously at a thickness of 50 nm or more" includes both a mode in which the SiOyNz region having the composition range (B) is present continuously at a thickness of 50 nm or more in a single gas barrier layer and a mode in which the SiOyNz region having the composition range (B) is present continuously at a thickness of 50 nm or more over at least two neighboring gas barrier layers.
Further, the SiOwNx region is disposed closer to the substrate while the SiOyNz is disposed farther from the substrate compared to the SiOwNx region, and between the substrate and the SiOwNx region, between the SiOwNx region and the SiOyNz region, or between the SiOyNz region and a surface of the gas barrier film (surface of a gas barrier layer present farthest from the substrate), a region having any composition may be present or no region may be present between them (each of them is in direct contact with each other).
The SiOwNx region and the SiOyNz region that are present in the gas barrier layer of the present invention contain silicon oxynitride, and it preferably is silicon oxynitride (it consists of silicon oxynitride). Herein, silicon oxynitride has a composition consisting of silicon, oxygen, and nitrogen as main constitutional elements. Each of constitutional elements other than those such as hydrogen or carbon, which is introduced from raw materials for film formation, a substrate, atmosphere, or the like, is preferably lower than 5%, and each of them is preferably lower than 2%. By having such composition (containing nitrogen, in particular), flexibility of the barrier layer is increased to yield higher freedom level of a shape (folding property, bending property, and flexibility). As a result, it is possible to perform curve processing and by having a dense layer, a barrier property against oxygen or water (water vapor) can be improved. Under an oxidative atmosphere, in particular in the presence of water vapor, silicon oxynitride is oxidized to transform into silicon oxide, and when expressed as composition of SiOv, it is finally transformed to a state of having v = 2.5 or so. It means that there is a portion in which a broken bond like -Si-OH HO-Si- is present without forming a Si-O-Si- bond, and thus the barrier property of a silicon oxynitride film is greatly deteriorated by oxidation.
Susceptibility of silicon oxynitride to oxidization varies greatly depending on combination of the ratio of O and ratio of N compared to Si. It is generally believed that having higher ratio of N than the ratio of O is stable against the oxidation. However, for having both the high gas barrier property and transparency that are required for a gas barrier film and also providing the film with flexibility, having a composition range that is merely stable against oxidization is not enough.
As a result of various determinations, we could obtain a gas barrier film having both a high gas barrier property and transparency and also good flexibility by laminating in specific order two kinds of silicon oxynitride region having different composition ratio range.
Hereinbelow, details of the constitutional elements of the gas barrier film of the invention are explained.

«Gas barrier film»

The gas barrier film of the present invention is characterized in that, it has a gas barrier layer consisting of silicon oxynitride containing Si, O, and N on at least one surface of a substrate, in which the gas barrier layer is divided into regions having at least two composition ranges in the thickness direction, in which the SiOwNx region having the composition range (A) is present continuously at a thickness of 20 nm or more at a side closer to the substrate and the SiOyNz region having the above composition range (B) is present continuously at a thickness of 50 nm or more at a

side farther from the substrate. By forming a gas barrier layer other than those at any position in thickness direction, the gas barrier property can be further enhanced. It is also possible to have a constitution that the gas barrier layer is formed on both surfaces of the substrate.

[Substrate]

The substrate used in the present invention is a long support which can hold a gas barrier layer (simply referred to as a "barrier layer") having gas barrier property (simply referred to as a "barrier property") explained below, and it is formed of the following materials, but not limited thereto.

Examples may include various resin films of acrylic acid ester, methacrylic acid ester, polyethylene terephthalate (PET), polybutylene terephthalate, polyethylene naphthalate (PEN), polycarbonate (PC), polyallylate, polyvinyl chloride (PVC), polyethylene (PE), polypropylene (PP), polystyrene (PS), nylon (NY), aromatic polyamide, polyether ether ketone, polysulfone, polyether sulfone, polyimide, polyether imide and so on, a heat resistant transparent film having, as a basic skeleton, silsesquioxane having an organic inorganic hybrid structure (for example, product name Sila-DEC; manufactured by CHISSO Corporation and product name Silplus; manufactured by Nippon Steel & Sumikin Chemical Co., Ltd.), and resin films formed by laminating two or more layers of the aforementioned resin.

Polyethylene terephthalate (PET), polybutylene terephthalate, polyethylene naphthalate (PEN), polycarbonate (PC) and so on are suitably used in terms of costs and ease of acquisition, and the heat resistant transparent film having, as a basic skeleton, silsesquioxane having an organic inorganic hybrid structure can be suitably used in terms of optical transparency, heat resistance, and adhesion with an inorganic layer and a gas barrier layer.

Meanwhile, when the gas barrier film is used for an electronic device application in a flexible display, the processing temperature may be higher than 200°C during an array manufacturing method. In case of a roll-to-roll manufacture, a certain amount of tension is constantly applied to a substrate. As such, when the substrate temperature increases as the substrate is placed under high temperature, elasticity of the substrate dramatically decreases once the substrate temperature becomes higher than glass transition temperature, and thus the gas barrier layer may suffer from damages as the substrate is elongated due to tension. It is preferable to use, as a substrate for such applications, a heat resistant material having glass transition temperature of at least 150°C. Specifically, it is preferable to use polyimide, polyether imide, or a heat resistant transparent film having, as a basic skeleton, silsesquioxane having an organic inorganic hybrid structure. However, as the heat resistant resin represented by them is non-crystalline, it has higher water absorbency value and higher dimensional change of a substrate caused by humidity compared to crystalline PET or PEN, and thus the gas barrier layer may suffer from damages. However, even when those heat resistant materials are used as a substrate, by forming a gas barrier layer on both surfaces, the dimensional change caused by water absorption and desorption by the substrate film itself under severe condition of high temperature and high humidity can be suppressed, and thus damages occurring on the gas barrier layer can be suppressed. Thus, using a heat resistant material as a substrate and forming a gas barrier layer on both surfaces corresponds to one of the preferred embodiments.

The thickness of the substrate is preferably 5 to 500 $\mu$m or so, and more preferably 25 to 250 $\mu$m.

Further, the substrate is preferably transparent. Herein, a transparent substrate means that it has light transmission of 80% or higher for visible ray (400 to 700 nm). Meanwhile, the visible ray transmission indicates a value calculated according to the standards of JIS R3106 (1985).

By having a transparent substrate and also a transparent gas barrier layer formed on a substrate, a transparent gas barrier film can be provided, and thus a transparent substrate such as an organic EL element can be also produced.

Further, the substrate using the resin described above may be either a non-stretched film or a stretched film.

The substrate used in the invention can be produced by a previously well-known general method. For example, by melting a resin as a material by an extruder, and extruding the molten resin through a ring die or a T die to be rapidly cooled, an unstretched substrate, which is substantially amorphous and is not oriented, can be produced.

Furthermore, a stretched substrate can be produced by stretching an unstretched substrate in a substrate-flowing direction (longitudinal direction) or a direction perpendicular to the substrate-flowing direction (lateral direction) by a well-known method such as uniaxial stretching, tenter type sequential biaxial stretching, tenter type simultaneous biaxial stretching, or tubular simultaneous biaxial stretching.

The stretching ratio in this case can be appropriately selected according to a resin as a raw material of the substrate, but is preferably 2 times to 10 times in each of longitudinal and lateral directions.

Further, to enhance the dimensional stability of a substrate in a stretched film, it is preferable to perform a relaxing treatment after stretching.

The substrate according to the present invention can be subjected to various treatments that are known to be useful for enhancing adhesiveness such as a corona discharge treatment, a flame treatment, an oxidation treatment, a plasma treatment, or lamination of a primer layer, either singly or in combination as necessary, on a surface (on a side at which the gas barrier layer is formed) before the gas barrier layer is formed.

[Intermediate layer]

In the gas barrier film of the present invention, various intermediate layers having different function can be formed.

(Anchor coat layer)

On a surface at which a coating film (gas barrier layer) of the substrate according to the present invention is formed, an anchor coat layer may be formed for the purpose of enhancing adhesiveness to the gas barrier layer.
As an anchor coating agent use for the anchor coat layer, a polyester resin, an isocyanate resin, a urethane resin, an acryl resin, an ethylene vinyl alcohol resin, a vinyl-modified resin, an epoxy resin, a modified styrene resin, a modified silicon resin, an alkyl titanate, and the like can be used singly or in combination of two or more thereof.
To these anchor coating agents can also be added a previously well-known additive. The above-described anchor coating agent can be coated by applying it onto the substrate by a well-known method such as roll coating, gravure coating, knife coating, dip coating, or spray coating, and removing a solvent, a diluent and the like by drying. The coating amount of the above-described anchor coating agent is preferably about 0.1 to 5.0 g/$m^2$ (dry state).
Further, the anchor coat layer may be formed by a gas phase method such as a physical vapor deposition method or a chemical vapor deposition method. For example, as disclosed in Japanese Unexamined Publication No. 2008-142941, for the purpose of improving adhesiveness or the like, an inorganic film having silicon oxide as a main component can be formed. Alternatively, by forming an anchor coat layer described in Japanese Unexamined Publication No. 2004-314626, it is also possible that, for the purpose of controlling the composition of an inorganic thin film by blocking at certain level the gas generated from a substrate side, an anchor coat layer may be formed when an inorganic thin film is formed by the gas phase method.
Further, thickness of the anchor coat layer is preferably 0.5 to 10.0 μm or so, although not particularly limited.

(Flat and smooth layer)

The gas barrier film according to the present invention may have a flat and smooth layer between a substrate and a gas barrier layer. The flat and smooth layer used in the invention is provided for flattening the rough surface of a transparent resin film substrate, on which projections and the like are present, or flattening a transparent inorganic compound layer by filling up unevenness and pinholes generated thereon by projections present on the transparent resin film substrate. Such a flat and smooth layer is formed basically by curing a photosensitive material or a thermosetting material.
Examples of the photosensitive material used for the flat and smooth layer include a resin composition containing an acrylate compound having a radical-reactive unsaturated compound, a resin composition containing an acrylate compound and a mercapto compound having a thiol group, and a resin composition with a polyfunctional acrylate monomer dissolved therein such as epoxy acrylate, urethane acrylate, polyester acrylate, polyether acrylate, polyethylene glycol acrylate, or glycerol methacrylate. Specifically, a UV curable organic/inorganic hybrid hard coatingmaterial OPSTAR (registered trademark) series manufactured by JSR Corporation may be used. Further, any mixture of the resin compositions described above can also be used, and the photosensitive resin is not particularly limited as long as it contains a reactive monomer having at least one photopolymerizable unsaturated bond in a molecule.
Specific examples of the thermosetting material include Tutoprom series manufactured by Clariant (organic polysilazane), SP COAT heat resistant clear painting manufactured by Ceramic Coat Co., Ltd., nanohybrid silicone manufactured by Adeka Corporation, UNIDIC (registered trademark) V-8000 series manufactured by DIC Corporation, EPICLON (registered trademark) EXA-4710 (ultra high heat resistant epoxy resin), various silicone resins manufactured by Shin-Etsu Chemical Co., Ltd., inorganic/organic nanocomposite material SSG coat manufactured by Nitto Boseki Co., Ltd., a thermosetting urethane resin consisting of acryl polyol and isocyanate prepolymer, a phenol resin, a urea melamine resin, an epoxy resin, an unsaturated polyester resin, and a silicone resin, and the like. Among them, a material as an epoxy resin base having heat resistance is particularly preferable.
The method of forming the flat and smooth layer is not particularly limited, but a wet coating method such as a spin coating method, a spray coating method, a blade coating method, or a dipping method, or a dry coating method such as a vapor deposition method is preferable.
For formation of the flat and smooth layer, additives such as an antioxidant, an ultraviolet ray absorbing agent, and a plasticizer can be added to the above-mentioned photosensitive resin as necessary. In any flat and smooth layers, regardless of the position at which the flat and smooth layer is laminated, resins and additives suitable for improvement film formability and prevention of generation of pinholes in the film or the like may be added.
Thickness of the flat and smooth layer is preferably in the range of 1 μm to 10 μm, and more preferably in the range of 2 μm to 7 μm, from the viewpoint of easily adjusting the balance of the optical characteristics of the smooth

film by enhancing the heat resistance of the film.

The smoothness of the flat and smooth layer is, in terms of 10-point average roughness Rz, preferably 10 nm to 30 nm as a value expressed by a surface roughness defined in JIS B 0601 (2001). When it is within the range, coatability may not be impaired when a coating means becomes in contact with the surface of the flat and smooth layer by a coating method with a wire bar, a wireless bar or the like, even when the barrier layer is coated in a coating manner, and also it becomes easy to smooth unevenness after the coating.

(Bleed out preventing Layer)

The gas barrier film according to the invention may have a bleed out preventing layer on a surface of the substrate which is opposite to the surface having a flat and smooth layer formed thereon.

The bleed out preventing layer is provided on the opposite surface of the substrate having a flat and smooth layer for the purpose of suppressing such a phenomenon that unreacted oligomers and so on are transferred from the interior to the surface of the film substrate to contaminate the contact surface when the film having the flat and smooth layer is heated. The bleed out preventing layer may have essentially the same structure as that of the flat and smooth layer as long as it has the function described above.

As an unsaturated organic compound having a polymerizable unsaturated group, which can be included as a hard coating agent in the bleed out preventing layer, a polyvalent unsaturated organic compound having two or more polymerizable unsaturated groups in a molecule or a monovalent unsaturated organic compound having one polymerizable unsaturated group in a molecule may be taken as an example.

As other additives, a matting agent may be contained. As the matting agent, inorganic particles having an average particle diameter of about 0.1 to 5 μm are preferable. As these inorganic particles, silica, alumina, talc, clay, calcium carbonate, magnesium carbonate, barium sulfate, aluminum hydroxide, titanium dioxide, zirconium oxide, and the like can be used singly or in combination of two or more thereof.

Here, it is desirable that the matting agent formed of inorganic particles be mixed at a ratio of 2 parts by weight or more, preferably 4 parts by weight or more, and more preferably 6 parts by weight or more, and 20 parts by weight or less, preferably 18 parts by weight or less, and more preferably 16 parts by weight or less based on 100 parts by weight of the solid content of the hard coating agent.

The bleed out preventing layer may also contain a thermoplastic resin, a thermosetting resin, an ionizing radiation-curable resin, a photopolymerization initiator and so on as components other than the hard coating agent and matting agent.

The bleed out preventing layer described above can be formed by mixing a hard coating agent, a matting agent, and other components as necessary, preparing a coating liquid from the mixture with a diluent solvent that is appropriately used as necessary, coating the surface of the support film with the coating liquid by a previously well-known coating method, and thereafter curing the coated film by applying an ionizing radiation.

Meanwhile, a method for applying an ionizing radiation can be carried out by applying an ultraviolet ray having a wavelength in a range of 100 to 400 nm and preferable of 200 to 400 nm, which is emitted from an ultra-high pressure mercury lamp, a high pressure mercury lamp, a low pressure mercury lamp, a carbon arc, a metal halide lamp or the like, or applying an electron beam haying a wavelength in a range of 100 nm or less, which is emitted from a scan type or curtain type electron beam accelerator.

It is desirable that the thickness of the bleed out preventing layer is in the range of 1 to 10 μm and preferably 2 to 7 μm from the viewpoint that the heat resistance of the film is improved for easy control of the balance of the optical characteristics of the film and also curls of the barrier film is suppressed in a case where the bleed-out preventing layer is provided on only one surface of the gas barrier film.

[Gas barrier layer]

According to the present invention, at least two of the gas barrier layers containing at least Si, O, and N are present (hereinbelow, simply referred to as a gas barrier layer or a barrier layer). It is advantageous from the viewpoint that the gas barrier property is significantly enhanced when at least two gas barrier layers are present.

An upper limit of the number of the gas barrier layer is, although not particularly limited, generally 10 or less from the viewpoint of transparency or productivity. In other words, preferably 2 to 10 layers, and preferably 2 to 6 layers of the gas barrier layers are laminated on a substrate. Meanwhile, as a layer constituting the gas barrier layer, another layer having gas barrier property may be present.

The gas barrier layer according to the present invention may be formed by a known physical vapor deposition method or a chemical vapor deposition method.

Generally, as a method for forming a functional thin film on a substrate, there are roughly classified into a physical vapor growing method and a chemical vapor growth method (chemical vapor deposition method). The physical

vapor growth method is a method of depositing a thin film of a target substance with a physical technique on a surface of substance in a gas phase. Examples of this method include: a vapor deposition method (resistance heating method, electron beam vapor deposition method, and molecular epitaxy method), an ion plating method, and a sputtering method. On the other hand, a chemical vapor growing method (Chemical Vapor Deposition) is a method of supplying a raw material gas containing a target component for a thin film to deposit a film by a chemical reaction on a substrate surface or in a gas phase. In order to activate a chemical reaction, there is a method to produce plasma or the like. Known CVD examples include: a thermal CVD method, a catalytic chemical vapor growth method, a photo CVD method, a plasma CVD method, and an atmospheric pressure CVD method. In the present invention, any method can be advantageously used.

As for the physical vapor deposition method or chemical vapor deposition method, the composition and film thickness of silicon oxynitride can be controlled by a known method.

Although the gas barrier layer of the present invention contains silicon oxynitride, it is preferably formed with polysilazane. Specifically, the gas barrier layer of the present invention can be also formed by applying a coating liquid containing polysilazane on a substrate or a neighboring layer and performing vacuum ultraviolet ray irradiation onto a dried layer containing polysilazane. Since the forming by coating which does not require a vacuum process is desirable in terms of productivity and cost, according to the present invention, the gas barrier layer containing at least Si, O, and N is preferably a layer formed by performing vacuum ultraviolet ray irradiation onto a layer containing polysilazane.

(Layer containing polysilazane)

The gas barrier layer according to the present invention is preferably formed by performing vacuum ultraviolet ray irradiation onto a layer formed by applying a solution containing polysilazane (a layer containing polysilazane).

As for the method of applying a coating liquid containing polysilazane on a substrate or a neighboring layer, any suitable method may be used.

Specific examples thereof include a spin coating method, a roll coating method, a flow coating method, an inkj et method, a spray coating method, a printing method, a dip coating method, a cast film forming method, a bar coating method, a wireless bar coating method, and Gravure method.

"Polysilazane" according to the present invention is a polymer having a silicon-nitrogen bond in the structure and is a precursor polymer such as $SiO_2$, $Si_3N_4$, or an intermediate solid solution of ($SiO_pN_q$) containing Si-N, Si-H, N-H bond, or the like.

In order to apply the coating liquid without deteriorating the film substrate, it is preferably a compound which is modified into silicon oxynitride at a relatively low temperature as described in Japanese Unexamined Publication No. 8-112879.

As for the compound to be modified into silicon oxynitride, those having following structure are preferably used.

[Chem. 1] $-[Si(R_1)(R_2)-N(R_3)]-$

In the formula, $R^1$, $R^2$ and $R^3$ each respectively represent a hydrogen atom, an alkyl group, an alkenyl group, a cycloalkyl group, an aryl group, an alkylsilyl group, an alkylamino group, or an alkoxy group, which may be substituted or unsubstituted.

At that time, each of $R_1$, $R_2$ and $R_3$ may be the same or different from each other.

Herein, examples of the alkyl group include a linear or branched alkyl group having 1 to 20 carbon atoms, and preferably 1 to 8 carbon atoms. Specific examples thereof include a methyl group, an ethyl group, an n-propyl group, an isopropyl group, an n-butyl group, an isobutyl group, a sec-butyl group, a tert-butyl group, an n-pentyl group, an isopentyl group, a neopentyl group, an n-hexyl group, an n-heptyl group, an n-octyl group, and a 2-ethylhexyl group. Examples of the alkenyl group include an alkenyl group having 2 to 20 carbon atoms. Specific examples thereof include a vinyl group, an allyl group, a 1-butenyl group, a 2-butenyl group, a 2-pentenyl group, and a 3-pentenyl group. Examples of the cycloalkyl group include a cycloalkyl group having 3 to 20 carbon atoms, preferably 3 to 8 carbon atoms. More specific examples thereof include a cyclopropyl group, a cyclopentyl group, and a cyclohexyl group. Examples of the aryl group include an aryl group having 6 to 30 carbon atoms. More specific examples thereof include a non-fused hydrocarbon group such as a phenyl group, a biphenyl group, or a terphenyl group; and a fused polycyclic hydrocarbon group such as a pentalenyl group, an indenyl group, a naphthyl group, an azulenyl group, a heptalenyl group, a biphenylenyl group, a fluorenyl group, an acenaphthylenyl group, a pleiadenyl group, an acenaphthenyl group, a phenalenyl group, a phenanthryl group, an anthryl group, a fluoranethenyl group, an acephenanthrylenyl group, an aceanthrylenyl group, a triphenylenyl group, a pyrenyl group, a chrysenyl group, and a naphthacenyl group. Examples of the alkyl silyl group include a silyl group having an alkyl group with 1 to 20 carbon atoms. Specific examples thereof include a trimethylsilyl group, a triethylsilyl group, a triisopropylsilyl group, a tert-butyl dimethylsilyl group, and a tert-butyl diphenylsilyl

group, and the like. Examples of the alkylamino group include a substituent group in which the aforementioned alkyl group is bound via an amino bonding. Examples of the alkoxy group include an alkoxy group having 1 to 20 carbon atoms, and preferably 1 to 8 carbon atoms. Specific examples thereof include a methoxy group, an ethoxy group, an isopropoxy group, a tert-butoxy group, an n-octyloxy group, an n-decyloxy group, an n-hexadecyloxy group, a 2-ethylhexyloxy group, and a 2-hexyldecyloxy group, and the like.

The substituent group which may be present depending on a case on the aforementioned $R_1$ to $R_3$ is not particularly limited, and examples thereof include an alkyl group, a halogen atom, a hydroxy group (-OH), a mercapto group (-SH), a cyano group (-CN), a sulfo group ($-SO_3H$), a carboxy group (-COOH), and a nitro group ($-NO_2$). Meanwhile, the substituent group which may be present depending on a case is not the same as the $R_1$ to $R_3$ to be substituted. For example, when $R_1$, $R_2$ and $R_3$ are an alkyl group, it is not further substituted with an alkyl group. Among them, $R_1$, $R_2$ and $R_3$ are preferably a hydrogen atom, a methyl group, an ethyl group, a propyl group, an isopropyl group, a butyl group, an isobutyl group, a tert-butyl group, a phenyl group, a vinyl group, a 3-(triethoxysilyl)propyl group, or a 3-(trimethoxysilylpropyl) group.

It is also preferable that the polysilazane having the structure represented by the above formula have a number average molecular weight of 150 to 150,000 g/mol.

From the viewpoint of film density of the obtained gas barrier layer in the present invention, perhydropolysilazane in which all of $R_1$, $R_2$ and $R_3$ are a hydrogen atom is particularly preferable.

According to an application, the perhydropolysilazane and organopolysilazane may be selected and they may be used as a mixture.

Perhydropolysilazane is presumed to have a structure containing a straight chain and a ring structure mainly composed of a 6- and 8-memberd ring.

Its molecular weight is about 600 to 2,000 (polystyrene conversion value based on gel permeation chromatography) in terms of a number average molecular weight (Mn). It is amaterial of liquid or solid, and the state differs depending on the molecular weight.

They are commercially available in a solution state in which they are dissolved in an organic solvent. The commercially available product itself can be used as a coating liquid containing polysilazane. Examples of the commercially available coating liquid containing polysilazane include AQUAMICA (registered trademark) NN120-10, NN120-20, NAX120-20, NN110, NN310, NN320, NL110A, NL120A, NL120-20, NL150A, NP110, NP140, SP140 and the like, that are manufactured by AZ Electronic Materials.

Another examples of polysilazane compound which is converted to silicon oxynitride at low temperature include silicon alkoxide added polysilazane, being produced by reacting silicon alkoxide with polysilazane (for example, refer to Japanese Unexamined Publication No. 5-238827); glycidol added polysilazane, being produced by reacting glycidol (for example, refer to Japanese Unexamined Publication No. 6-122852); alcohol added polysilazane, being produced by reacting alcohol (for example, refer to Japanese Unexamined Publication No. 6-240208); metal carboxylic acid added polysilazane, being produced by reacting metal carboxylate (for example, refer to Japanese Unexamined Publication No. 6-299118); acetyl acetonate complex added polysilazane, being produced by reacting acetyl acetonate complex containing a metal (for example, refer to Japanese Unexamined Publication No. 6-306329); and metal fine particle added polysilazane, being produced by adding metal fine particles (for example, refer to Japanese Unexamined Publication No. 7-196986).

As an organic solvent to prepare a coating liquid containing polysilazane, it is preferable to avoid using an alcoholic solvent or those containing moisture which easily react with polysilazane, although it is not particularly limited if it can dissolve polysilazane.

Examples of the organic solvent used for preparation of a coating liquid containing polysilazane include a hydrocarbon solvent such as an aliphatic hydrocarbon, an alicyclic hydrocarbon or an aromatic hydrocarbon; a halogenated hydrocarbon solvent; an ether such as an aliphatic ether, or an alicyclic ether. In particular, usable solvents include: an aliphatic hydrocarbons such as pentane, hexane, cyclohexane, toluene, xylene, SOLVESSO, and TARBEN; halogenated hydrocarbons such as methylene chloride, or trichloroethane; esters such as ethyl acetate or butyl acetate; ketones such as acetone or methyl ethyl ketone; and ethers such as dibutyl ether, dioxane, or tetrahydrofuran.

These organic solvents may be chosen in accordance with the purpose, such as solubility of polysilazane, and an evaporation rate of an organic solvent, and plural organic solvents may be mixed.

Although the polysilazane concentration in the coating liquid containing polysilazane varies in accordance with the film thickness of the plural gas barrier layer on which coating is formed or the pot life of the coating liquid, it is preferable to be about 0.2 to 35% by weight.

The polysilazane may be a derivative in which the hydrogen part binding to the Si is partially substituted with an alkyl group or the like.

By having an alkyl group, in particular, a methyl group with the smallest molecular weight, adhesiveness to a base (substrate or neighboring layer) is improved and also toughness can be given to a silica film, which is brittle as being hard, and thus an occurrence of cracks is suppressed even when the film thickness is increased.

In order to promote the modification into a silicon oxide compound, a catalyst such as an amine or a metal can also be added. As an applicable catalyst, a basic catalyst is preferable. In particular, an amine catalyst such as N,N-diethylethanolamine, N,N-dimethylethanolamine, triethanolamine, triethylamine, 3-morpholino propylamine, N,N,N',N'-tetramethyl-1,3-diaminopropane, or N,N,N',N'-tetramethyl-1,6-diaminohexanoic acid, a metal catalyst including a Pt compound such as Pt acetyl acetonate, a Pd compound such as Pd propionate, and a Rh compound such as Rh acetylacetonate, and an N-heterocyclic compound can be exemplified. Among them, it is preferable to use an amine catalyst. While taking polysilazane as a reference, a concentration of the catalyst to be added is usually within a range of 0.1 to 10% by mol, preferably, within a range of 0. 5 to 7% by mol. By having an addition amount of the catalyst within the range, having an excessive formation amount of silanol, a decrease in film density, and an increase in film defects that are caused by a rapid progress of the reaction can be avoided.

In the coating liquid containing polysilazane, a reaction catalyst may be added, if necessary. In order to avoid having an excessive formation amount of silanol, a decrease in film density, and an increase in film defects that are caused by the catalyst, the addition amount of the catalyst (solid content) is preferably adjusted to 2% by weight or lower with respect to polysilazane.

In the coating liquid containing polysilazane, an inorganic precursor compound other than polysilazane may be contained. The inorganic precursor compound other than polysilazane is not particularly limited if it allows preparation of the coating liquid.

Specific examples of a silicon-containing compound include polysiloxane, polysilsesquioxane, tetramethylsilane, trimethylmethoxysilane, dimethyldimethoxysilane, methyltrimethoxysilane, trimethylethoxysilane, dimethyldiethoxysilane, methyltriethoxysilane, tetramethoxysilane, tetramethoxysilane, hexamethyldisiloxane, hexamethyldisilazane, 1,1-dimethyl-1-silacyclobutane, trimethyl vinyl silane, methoxy dimethyl vinyl silane, trimethoxy vinyl silane, ethyl trimethoxy silane, dimethyl divinyl silane, dimethyl ethoxyethynyl silane, diacetoxy dimethyl silane, dimethoxymethyl-3,3,3-trifluoropropylsilane, 3,3,3-trifluoropropyl trimethoxysilane, aryl trimethoxysilane, ethoxy dimethyl vinyl silane, aryl aminotrimethoxysilane, N-methyl-N-trimethylsilyl acetamide, 3-aminopropyl trimethoxysilane, methyl trivinyl silane, diacetoxymethyl vinyl silane, methyltriacetoxy silane, aryloxydimethyl vinyl silane, diethyl vinyl silane, butyl trimethoxysilane, 3-aminopropyl dimethylethoxysilane, tetravinyl silane, triacetoxy vinyl silane, tetraacetoxy silane, 3-trifluoroacetoxypropyl trimethoxysilane, diaryl dimethoxysilane, butyldimethoxy vinyl silane, trimethyl-3-vinyl thiopropylsilane, phenyl trimethylsilane, dimethoxy methylphenylsilane, phenyltrimethoxysilane, 3-acryloxypropyl dimethoxymethylsilane, 3-acryloxypropyl trimethoxysilane, dimethyl isopentyl vinyl silane, 2-aryloxyethyl thiomethoxy trimethylsilane, 3-glycidoxypropyl trimethoxysilane, 3-arylaminopropyl trimethoxysilane, hexyl trimethoxysilane, heptadecafluorodecyl trimethoxysilane, dimethyl ethoxy phenylsilane, benzolyoxy trimethylsilane, 3-methacryloxypropyl dimethoxymethyl silane, 3-methacryloxypropyl trimethoxysilane, 3-isocyanate propyl triethoxysilane, dimethylethoxy-3-glycidoxypropylsilane, dibutoxy dimethylsilane, 3-butylaminopropyl trimethylsilane, 3-dimethylaminopropyl diethoxymethylsilane, 2-(2-aminoethylthioethyl)triethoxysilane, bis(butylamino)dimethylsilane, divinylmethyl phenylsilane, diacetoxymethyl phenylsilane, dimethyl-p-tolyl vinyl silane, p-styryltrimethoxysilane, diethylmethylphenylsilane, benzyldimenthylethoxysilane, diethoxymethylphenylsilane, decylmethyldimethoxysilane, diethyxy-3-glycidoxypropylmethylsilane, octyloxytrimethylsilane, phenyltrivinyl silane, tetra-aryloxysilane, dodecyltrimethylsilane, diarylmethylphenylsilane, diphenylmethyl vinyl silane, diphenylethoxymethylsilane, diacetoxydiphenylsilane, dibenzyldimethylsilane, diaryldiphenylsilane, octadecyltrimethylsilane, methyloctadecyldimethylsilane, dococylmethyldimethylsilane, 1,3-divinyl-1,1,3,3-tetramethyl disiloxane, 1,3-divinyl-1,1,3,3-tetramethyl disilazane, 1,4-bis(dimethylvinylsilyl)benzene, 1,3-bis(3-acetoxypropyl)tetramethyl disiloxane, 1,3,5-trimethyl-1,3,5-trivinyl cyclotrisiloxane, 1,3,5-tris(3,3,3-trifluoropropyl)-1,3,5-trimethyl cyclotrisiloxane, octamethyl cyclotetrasiloxane, 1,3,5,7-tetraethoxy-1,3,5,7-tetramethyl cyclotetrasiloxane, and decamethyl cyclopentasiloxane.

As for the polysiloxane, those having highly reactive Si-H are preferable, and Methyl hydrogen polysiloxane is preferable. Examples of the methyl hydrogen polysiloxane include TSF484 manufactured by Momentive Performance Materials Inc.

As for the polysilsesquioxane, those having any structure of a basket shape, a ladder shape, and a random shape can be preferably used. Examples of polysilsesquioxane with basket shape include products supplied as Q8 series manufactured by Mayaterials Inc. such as: Octakis(tetramethylammonium)pentacyclo-octasiloxane-octa kis(yloxide)hydrate; Octa(tetramethylammonium)silsesquioxane, Octakis(dimethylsiloxy)octasilsesquioxane, Octa[[3-[(3-ethyl-3-oxetanyl)methoxy]propyl]dimethylsilo xy)]octasilsesquioxane; Octaallyloxetane silsesquioxane, Octa[(3-Propylglycidylether)dimethylsiloxy]silsesquioxan e; Octakis[[3-(2,3-epoxypropoxy)propyl]dimethylsiloxy]octas ilsesquioxane, Octakis[[2-(3,4-epoxycyclohexyl)ethyl]dimethylsiloxy]oct asilsesquioxane, Octakis[2-(vinyl)dimethylsiloxy]silsesquioxane; Octakis (dimethylvinylsiloxy)octasilsesquioxane, Octakis[(3-hydroxypropyl)dimethylsiloxy]octasilsesquioxa ne, Octa[(methacryloylpropyl)dimethylsilyloxy]silsesquioxane, or Octakis[(3-methacryloxypropyl)dimethylsiloxy]octasilsesq uioxane. Examples of the polysilsequioxane which is believed to have a mixed structure of a basket shape, a ladder shape and a random shape include SR-20, SR-21, SR-23 as polyphenylsilsesquioxane, SR-13 as polymethylsilsesquioxane, and SR-33 as polymethyl phenylsilsesquioxan that are manufactured by Konish Chemical Ind. Co., Ltd. Further, the FOX series manufactured by Dow Corning Toray Co., Ltd., which is a solution of polyhydrogen

silsesquioxane as a commercially available material for spin-on-glass, can be also preferably used.

Among the compounds described above, an inorganic silicon compound present as a solid at room temperature is preferable and hydrogenated silsesquioxane is more preferable.

Further, when the coating liquid contains a solvent, it is preferable to dry the solvent in the coating film formed with polysilazane, before vacuum ultraviolet ray irradiation. At that time, it may be under a condition in which moisture is removed. Although high temperature is preferable from the viewpoint of rapid treatment as for drying temperature, it is preferable to determine temperature and a processing time suitably in consideration of the heat damage to a resin film substrate. For example, when using a polyethylene terephthalate substrate of which glass transition temperature (Tg) is 70°C as a plastic substrate, a heat treatment temperature can be set at 200°C or lower. As for the processing time, it is preferable to set up to be a short time so that the solvent may be removed and the heat damage to the substrate may be minimized, and when the drying temperature is 200°C or lower, it can be set up within 30 minutes.

(Vacuum ultraviolet ray irradiation process)

In the present invention, the preferable modification (conversion of polysilazane into silicon oxynitride) method is a treatment by irradiation of vacuum ultraviolet rays. The gas barrier layer according to the present invention is preferably formed by irradiating a layer formed by applying a solution containing polysilazane with vacuum ultraviolet rays. The treatment by irradiation of vacuum ultraviolet rays uses a light energy of 100 to 200 nm which is greater than the atomic bonding force in the polysilazane compound. Preferably, by using a light (VUV) energy of 100 to180 nm, an atomic bonding is directly broken only by an action of photon called as a photon process and formation of Si-N bond by dehydrogenation or an oxidation reaction by active oxygen or ozone is allowed to proceed. Thereby, formation of a silicon oxynitride film can be achieved at a relatively low temperature. By this process, at least part of polysilazane is modified into silicon oxynitride, and in a partial region in thickness direction of the layer, the gas barrier layer represented by the aforementioned composition SiOwNx or the gas barrier layer represented by the aforementioned composition SiOyNz is formed. Herein, even for a case in which hydrogen and carbon are present, it is preferable that no carbon atom is substantially present in the gas barrier layer to obtain a good gas barrier property, although it is not expressed by the composition formula. To increase the stability of the gas barrier layer, it is preferable to have less hydrogen atoms.

The vacuum ultraviolet ray irradiation may be carried out either once or carried out repeatedly twice or more times.

Herein, a presumed mechanism for having modification of a layer containing polysilazane by a vacuum ultraviolet ray irradiation process to obtain a specific composition of SiOaNb is described in view of perhydropolysilazane as an example.

Perhydropolysilazane can be expressed by the composition of "- $(SiH_2\text{-}NH)n$-." When it is expressed by SiOaNb, a = 0 and b = 1. To have a > 0, an external oxygen source isnecessary. Inthisregard, (i) oxygenormoisturecontained in polysilazane coating liquid, (ii) oxygen or moisture incorporated into a coating film from an atmosphere during a coating and drying process, (iii) oxygen, moisture, ozone, or singlet oxygen incorporated into a coating film from an atmosphere during a vacuum ultraviolet ray irradiation process, (iv) oxygen or moisture migrating as an out gas from a substrate side into a coating film caused by heat or the like applied during a vacuum ultraviolet ray irradiation process, or (v) when the vacuum ultraviolet ray irradiation process is performed in a non-oxidative atmosphere, oxygen or moisture incorporated into a coating film from an atmosphere when a shift is made from a non-oxidative atmosphere to an oxidative atmosphere, becomes an oxygen source. By suitably combining them, values a and b of the composition represented by SiOaNb can be adjusted.

Meanwhile, regarding b, since the condition for Si to undergo nitridation than oxidation is believed to be highly extraordinary, an upper limit of b is basically 1.

Further, in view of the relation among bonding arms of Si, O, and N, a and b are basically in the range of $2a + 3b \leq 4$. In a state where b = 0, that is, fully progressed oxidation state, a silanol group is contained in the coating film, and there may be a case in which a is in the range of $2 < a < 2.5$.

A reaction mechanism presumed to be involved with an occurrence of silicon oxynitride by the vacuum ultraviolet ray irradiation process is described hereinbelow.

(I) Dehydrogenation and formation of Si-N bond accompanied therewith

It is believed that Si-H bond or N-H bond in perhydropolysilazane is relatively easily broken by excitation or the like by vacuum ultraviolet ray irradiation and binds again as Si-N under an inert atmosphere (non-bonding arm of Si may be also formed). That is, it is cured as SiNy composition without oxidation, and thus breakage of a polymer main chain does not occur. Breakage of Si-H bond or N-H bond is promoted by presence of a catalyst or by heating. Broken H is released as $H_2$ to an outside of the film.

(II) Formation of Si-O-Si bond by hydrolysis and dehydration condensation

According to hydrolysis of Si-N bond in perhydropolysilazane by water and breakage of a polymer main chain, Si-OH is formed. According to dehydration condensation of two Si-OH, curing is obtained with formation of Si-O-Si bond. Although the reaction occurs also in air, it is believed that, during vacuum ultraviolet ray irradiation under an inert atmosphere, water vapor generated as an out gas from a substrate caused by heat of irradiation is believed to a main source of moisture. When moisture is present in an excessive amount, Si-OH not consumed by dehydration condensation remains, and thus a curing film with low gas barrier property that is represented by the composition of $SiO_{2.1}$ to $SiO_{2.5}$ is yielded.

(III) Direct oxygenation and formation of Si-O-Si bond caused by singlet oxygen

When a suitable amount of oxygen is present in an atmosphere during vacuum ultraviolet ray irradiation, singlet oxygen having greatly high oxidizing ability is formed. H and N in perhydropolysilazane are replaced with O to form a Si-O-Si bond, and thus causing curing. It is also considered that recombination of bonds may also occur according to breakage of a polymer main chain.

(IV) Oxidation accompanied with Si-N bond breakage caused by vacuum ultraviolet ray irradiation and excitation

It is believed that, since energy of vacuum ultraviolet ray is greater than the bond energy of Si-N in perhydropolysilazane, Si-N bond is broken and oxidized to generate Si-O-Si bond (or Si-O-N bond depending on a case) when an oxygen source (oxygen, ozone, water, or the like) is present in the neighborhood. It is believed that recombination of bonds may also occur according to breakage of a polymer main chain.

Adjusting the composition of silicon oxynitride in a layer which is obtained by performing vacuum ultraviolet ray irradiation on a layer containing polysilazane can be carried out by controlling an oxidation state by combining suitably the oxidation mechanisms (I) to (IV) described above.

Herein, the composition distribution in the thickness direction of the gas barrier layer can be obtained by measurement using a method based on XPS (photoelectron spectroscopy) analysis as described below.

Rate for etching the gas barrier layer of the present invention varies depending on the composition. Thus, in the present invention, a thickness for XPS analysis is first obtained based on etching rate converted in terms of $SiO_2$, a thickness per each gas barrier layer is obtained by, based on cross-sectional TEM image of the same sample, specifying interlayer interface of the gas barrier layer formed by lamination. While comparing the result with the thickness-wise composition distribution obtained from the XPS analysis, a region corresponding to each gas barrier layer is specified in the thickness-wise composition distribution. Subsequently, the thickness of each barrier layer obtained by XPS analysis is uniformly multiplied by a coefficient such that the thickness of each barrier layer obtained by XPS analysis and the thickness of each barrier layer obtained based on the cross-sectional TEM image, which correspond to each region, match with each other to perform thicknesswise calibration.

Although the XPS analysis is performed under the following condition in the present invention, when it is a measurement method based on the gist of the present invention, it can be applied without any problem even when the apparatus or measurement condition is changed.

According to the measurement method based on the gist of the present invention, as resolution mainly in thickness direction, the etching depth per single measurement point (corresponding to the following conditions of sputter ion and depth profile) is preferably 1 to 15 nm, and more preferably 1 to 10 nm. Under the following condition, the etching depth per single measurement point (etching rate) is 5.12 nm when converted to $SiO_2$.

Further, composition of the surface layer of the gas barrier layer of the present invention is obtained by measurement after sputtering the surface of the gas barrier layer under the following condition for 1 minute.

«Condition for XPS analysis»

- Apparatus: QUANTERASXM manufactured by ULVAC-PHI, INCORPORATED.
- X ray source: monochromatized Al-K$\alpha$
- Measurement range: Si2p, C1s, N1s, O1s
- Sputter ion: Ar (2 keV)
- Depth profile: measurement is repeated after sputtering for 1 minute
- Quantification: background is obtained by Shirley method, and quantification is made from an obtained peak area using relative sensitivity coefficient method. For data processing, MultiPak manufactured by ULVAC-PHI, INCORPORATED was used.

[SiOwNx region in gas barrier layer]

In the present invention, the gas barrier layer consisting of silicon oxynitride containing Si, O, and N is divided into regions having at least two thickness-wise composition ranges, and in one of the gas barrier layers, the SiOwNx region having the following composition range (A) is continuously present with a thickness of 20 nm or more. Further, the SiOwNx region is present closer to the substrate side than the SiOyNz region having the following composition range (B). When the composition of the gas barrier (A) is expressed as SiOwNx, $w \geq 0.8$, $x \geq 0.3$, and $2w + 3x \leq 4$. Herein, from the above relations, the upper limit of w is 1.55 and the upper limit of x is 0.8.

The SiOwNx region is a composition range in which oxidation resistance is considered to be more important than a gas barrier property. Since the SiOwNx region contains a relatively large amount of oxygen (w is relatively large), it also has good transparency. The SiOwNx region hardly undergoes a change in composition over a long period of time even when it is stored under high temperature and high humidity condition, and thus, it functions as a layer capable of maintaining constant gas permeability, for example water vapor permeability, over a long period of time. By having the SiOwNx region present continuously over 20 nm or more, the water vapor permeability can be lowered to a certain value or below, and according to combination with another composition range of the present invention, that is, the SiOyNz region, a very good gas barrier property can be exhibited.

A continuous thickness of the SiOwNx region is 20 nm or more, preferably 20 nm to 120 nm, and more preferably in the range of 40 nm to 100 nm. When it is 100 nm or less, the effect of lowering the gas barrier property never has a limiting point, and thus it is desirable in terms of productivity or cost. Further, there is no possibility of deterioration in flexibility caused by thickening of the total thickness of the gas barrier layer.

When the continuous thickness of the SiOwNx region is less than 20 nm, or the SiOwNx region is non-continuously present and it is as long as 20 nm or more in total, oxidation resistance is deteriorated, and thus constant gas permeability cannot be maintained for a long period of time. Although the mechanism of having such phenomenon remains unclear, it is believed that during a process of oxidation of a region adjacent to the SiOwNx region, oxidation of the SiOwNx region is also promoted. When there are plural SiOwNx regions, a "continuous thickness of the SiOwNx region" means the thickness of the region which has the highest thickness.

For controlling the composition and thickness of the SiOwNx region to the range of the present invention, the oxidation state can be controlled by oxygen supply described above, and it is not limited to a specific method.

As one detailedmethod, a method of forming the SiOwNx region to 20 nm or more by increasing introduction amount of an oxygen source at a surface side, which is achieved by adjusting oxygen concentration in an atmosphere at high level during vacuum ultraviolet ray irradiation of polysilazane layer, can be exemplified. The oxygen concentration can be suitably adjusted by heating temperature and an energy amount of vacuum ultraviolet ray irradiation. For one vacuum ultraviolet ray irradiation process, it is preferable to perform vacuum ultraviolet ray irradiation for a 10 to 500 nm polysilazane layer in an atmosphere with oxygen concentration of 0.3 to 4% by volume. It is more preferable to perform vacuum ultraviolet ray irradiation for a 15 to 300 nm polysilazane layer in an atmosphere with oxygen concentration of 0.5 to 3% by volume. The vacuum ultraviolet ray irradiation process can be performed either once or two or more times. The number of processes for repetition (the lamination times of the gas barrier layer) is preferably 1 to 3 times, and more preferably once, although it is suitably selected depending on a desired thickness of the SiOwNx region.

As another method, a controlling method by laminating thin layer of polysilazane of 10 to 40 nm or so is exemplified. According to this method, under a controlled oxidative atmosphere, the oxygen source introduced from both sides of the substrate and surface is more uniformly distributed in a total thickness direction of the layer during vacuum ultraviolet ray irradiation, and thus it becomes possible to have the total polysilazane thin layer in a thickness direction as the SiOwNx region. According to lamination of it, a thickness of the SiOwNx region can be also controlled freely. Condition for the vacuum ultraviolet ray irradiation can be suitably adjusted with the heating temperature and energy amount of the vacuum ultraviolet ray irradiation. For single vacuum ultraviolet ray irradiation process, it is preferable to perform vacuum ultraviolet ray irradiation for a 5 to 60 nmpolysilazane layer in an atmosphere with oxygen concentration of 0.01 to 4% by volume. It is more preferable to perform vacuum ultraviolet ray irradiation for a 10 to 40 nm polysilazane layer in an atmosphere with oxygen concentration of 0.05 to 2% by volume. The vacuum ultraviolet ray irradiation process can be performed either once or two or more times. Number of the process for repetition (lamination number of the gas barrier layer) is preferably 2 to 5 times, and more preferably 2 to 3 times, although it is suitably selected depending on a desired thickness of the SiOwNx region.

[SiOyNz region of gas barrier layer]

In the present invention, the gas barrier layer consisting of silicon oxynitride containing Si, O, and N is divided into regions having at least two thickness-wise composition ranges, and the SiOyNz region having the following composition range (B) is continuously present with a thickness of 50 nm or more farther from the substrate compared to the SiOwNx region having the composition range (A). When the composition of the gas barrier (B) is expressed as SiOyNz, $0 < y \leq 0.55$, $z \geq 0.55$, and $2y + 3z \leq 4$ are satisfied.

The SiOwNx region of the present invention has a good gas barrier property and also, in the long term, is a region capable of being oxidized as a result of reacting mostly with water vapor. Since it is a coating film formed by coating, it has less oxygen source introduced during vacuum ultraviolet ray irradiation, and has little nitrogen compound discharged from the coating film, and thus it has basically a very good gas barrier property. However, oxidation resistance of the SiOyNz region is not so high. Thus, in the gas barrier film of the present invention, the SiOwNx region is disposed closer to the substrate while the SiOyNz region is disposed farther from the substrate, the SiOyNz region is gradually oxidized according to the reaction while suppressing propagation of water vapor penetrated into the SiOyNz region via the SiOwNx region, and thus it is possible to capture water vapor without substantially having water vapor permeated into a region present before it, for example, a region in which an electronic device element is present. By having this region with a thickness of 50 nm or more, the water vapor can be continuously captured for a long period time which exceeds the warranty time of an electronic device. Further, considering better gas barrier property, the thickness is preferably 75 nm or more, and more preferably 100 nm or more. Further, the upper limit of the continuous thickness of the SiOwNx region is preferably 1. 0 μm or less, and more preferably 500 nm or less, since there is a limit in film thickness allowing favorable modification by vacuum ultraviolet ray irradiation process. For such reasons, a continuous thickness of the SiOyNz region is preferably 75 nm to 1.0μm, more preferably 100 nm to 1.0 μm, and even more preferably 100 nm to 500 nm. Meanwhile, when there are plural SiOyNz regions, a "continuous thickness of the SiOyNz region" means the thickness of the region which has the highest thickness.

More preferable composition range of the SiOyNz region is $0.25 \leq y \leq 0.55$, and also $0.55 \leq z \leq 0.75$. Because the SiOyNz region is also a layer which contains oxygen at a specific ratio, there is no problem in actual transparency.

When y is in the above range, the modification is more favorable, higher water vapor capturing ability (an ability to get oxidized) is shown, and a sufficient gas barrier property is obtained. According to the aforementioned presumed mechanism of the modification, the oxidation during modification may break the -Si-N-Si- bond, which is a main chain of polysilazane, and thus O is substituted with N. It is believed that bonds in the modified polysilazane with lower molecular weight re-bind to each other with denser structure at that time. Thus, it is believed that a sufficient gas barrier property is not obtained when O is not present in a certain amount of more. When y is higher than 0.55, although the gas barrier property is obtained, the water vapor capturing ability (an ability to get oxidized) is greatly lowered, and as a result, the water vapor permeability is increased as a whole gas barrier layer.

When z is smaller than 0.55, it also corresponds to a case in which oxidation of polysilazane progressed excessively, and although the gas barrier property is obtained, the water vapor capturing ability (that is, an ability to get oxidized) is greatly lowered, and as a result, the water vapor permeability as a gas barrier layer is increased. When z is within the above range, favorable modification is obtained, high water vapor capturing ability (an ability to get oxidized) is obtained, and a sufficient gas barrier layer is obtained.

Adjustment of the composition and thickness of the SiOyNz region to the range of the present invention can be carried out by controlling an oxidation state by controlling the oxygen supply described above, and it is not limited to a specific method. However, control of the composition of the SiOyNz region can be performed mainly by controlling oxygen or moisture migrating as an out gas from a substrate side to a coating film caused by heat or the like applied during a vacuum ultraviolet ray irradiation process.

For example, for single vacuum ultraviolet ray irradiation process, it is preferable to perform vacuum ultraviolet ray irradiation for a 5 to 60 nm polysilazane layer in an atmosphere with oxygen concentration of 0.01 to 4% by volume. It is more preferable to perform vacuum ultraviolet ray irradiation for a 10 to 40 nm polysilazane layer in an atmosphere with oxygen concentration of 0.05 to 2% by volume. The vacuum ultraviolet ray irradiation process can be performed either once or two or more times. Number of the process for repetition (lamination number of the gas barrier layer) is preferably 1 to 5 times, more preferably 1 to 3 times, and even more preferably once although it is suitably selected depending on a desired thickness of the SiOwNx region.

That is because oxygen or moisture migrating as an out gas from a substrate side to a coating film caused by heat or the like applied during a vacuum ultraviolet ray irradiation process is an important factor for modification of polysilazane by vacuum ultraviolet ray irradiation.

In the present invention, such control is performed by disposing the SiOwNx region at a side closer to the substrate. Since tiny oxygen source which permeates through the SiOwNx region may be required during vacuum ultraviolet ray irradiation for controlling the composition of the SiOyNz region, the SiOwNx region is not required to have a high gas barrier property. Thus, combination with the SiOwNx region of the present invention in which the oxidation resistance is emphasized is found to be highly appropriate.

For the vacuum ultraviolet ray irradiation process according to the present invention, vacuum ultraviolet ray irradiation intensity on the coating film, which is applied to the coating film of the polysilazane layer, is preferably 30 $mW/cm^2$ to 200 $mW/cm^2$ since there is no concern for damages on the substrate. More preferably, it is 50 $mW/cm^2$ to

160 mW/cm$^2$.

Energy amount of the vacuum ultraviolet ray irradiation on the coating film of the polysilazane layer (integrated irradiation energy) is preferably 200 mJ/cm$^2$ to 5, 000 mJ/cm$^2$ to have sufficient modification and no problems such as cracks or thermal deformation. More preferably, it is 500 mJ/cm$^2$ to 4,000 mJ/cm$^2$.

Further, other conditions for vacuum ultraviolet ray irradiation are not particularly limited. For example, temperature for vacuum ultraviolet ray irradiation (stage temperature) is preferably about 150°C or lower, and more preferably 20 to 100°C. Further, time for vacuum ultraviolet ray irradiation is preferably 0.1 to 10 min, and more preferably 2 to 300 seconds. Accordingly, successful conversion into a glass type mesh structure of silicon dioxide is achieved. Further, by directly initiating the oxidative conversion from a polysilazane skeleton to a three-dimensional $SiO_x$ mesh structure by using VUV photons, the conversion is made successfully within an extremely short time in single step. The order of mechanism for the conversion process can be described as follows: the Si-N bond is broken within a range of the penetration depth by VUV photons and the -$SiH_2$-NH-constitutional element is strongly excited by the absorption to the extent that layer conversion occurs in the presence of oxygen and water vapor. Meanwhile, the present invention is not limited to the following mechanism.

As for a light source of vacuum ultraviolet ray, a rare gas excimer lamp is preferably used. Atoms of rare gas such as Xe, Kr, Ar, or Ne are referred to as an inert gas because they do not form a molecule by chemical bonding.

However, atoms of rare gas which has obtained energy by discharge or the like (excited atoms) can form a molecule by binding with other atoms. For a case in which the rare gas is xenon, it is as follows:

$$e + Xe \rightarrow Xe^*$$

$$Xe^* + 2Xe \rightarrow Xe_2^* + Xe$$

$$Xe_2^* \rightarrow Xe + Xe + h\nu \ (172\ nm)$$

When $Xe_2^*$ as an excited excimer molecule is shifted to a ground state, excimer light of 172 nm is emitted.

As a characteristic of an excimer lamp, high efficiency can be mentioned because radiation is concentrated on one wavelength so that almost no light other than required light is radiated. Further, since no extra light is radiated, temperature of a subject can be maintained at low level. Further, since no time is required for activation and re-activation, it is possible to have instant lamp flickering.

For obtaining excimer radiation, a method of using a dielectric barrier discharge is known. According to the dielectric barrier discharge, a gas space is disposed between two electrodes via a dielectric body (for example, transparent quartz for an excimer lamp), a gas space is generated by applying several high voltage with high frequency of 10 kHz to the electrode, and according to discharge referred to as micro discharge that is extremely thin like thunder, charges are accumulated on a surface of the dielectric body when streamer of the micro discharge reaches the tubular wall (dielectric body), and as a result, the micro discharge is extinguished.

Thus, this micro discharge corresponds to discharge by which micro discharge is propagated on the entire tubular wall and undergoes repetition of generation and extinguishment. For such reasons, visually recognizable flickering of light is generated. Further, since the streamer at extremely high temperature locally but directly reaches on the tubular wall, there is a possibility to of cause a rapid deterioration of the tubular wall.

As a method of efficiently obtaining excimer radiation, electrodeless field discharge is also possible in addition to the dielectric barrier discharge. It is an electrodeless field discharge based on capacitive binding and is also referred to as RF discharge. Lamp and electrode and their arrangement may be basically the same as the dielectric barrier discharge. However, the high frequency applied between two electrodes has several tens of MHz. Accordingly, in electrodeless field discharge, since spatially and also timely uniform discharge is obtained, a lamp with long service life but without flickering can be obtained.

In case of dielectric barrier discharge, micro discharge occurs only between electrodes, and thus for performing discharge in an entire discharge space, an entire outer surface of an outer electrode needs to be covered, and the outer electrode needs to be capable of transmitting light to extract the light to an outside.

For such reasons, an electrode made of a thin metal wire in mesh type is used. For the electrode, a wire which is as thin as possible is used not to block light, and thus it may be easily damaged by ozone occurring by vacuum ultraviolet ray in an oxygen atmosphere. To prevent it, there is a need that surrounding of a lamp, that is, inside of the irradiation apparatus, is prepared to have an atmosphere of inert gas like nitrogen and irradiated light is extracted by installing a synthetic quartz window. Meanwhile, the synthetic quartz window is not only an expensive consumables but

also causes loss of light.

Among them, since a cylindrical lamp has an outer diameter of 25 mm or so, a difference in distance to an irradiation surface cannot be ignored from the position right below the lamp axis and the lateral surface of the lamp, and it generates a great difference in illuminance. Thus, even when lamps are arranged such that they are close to each other, uniform illuminance distribution is not obtained. However, with an irradiation apparatus installed with a synthetic quartz window, uniform distance in an oxygen atmosphere is achieved, and thus uniform illuminance distribution is obtained.

When electrodeless field discharge is employed, it is unnecessary to have a mesh type external electrode. Only by forming an external electrode on part of the outer surface of the lamp, glow discharge propagates to an entire discharge space. As an external electrode, an electrode also functioning as a light reflector made of an aluminum block is generally used on a rear surface of the lamp. However, since the outer diameter of the lamp is large like that in the dielectric barrier discharge, a synthetic quartz is required so as to have uniform illuminance distribution.

The biggest characteristic of the micro tube excimer lamp is that the structure is simple. Gas for performing excimer radiation is sealed inside only by closing both ends of quartz tube.

Outer diameter of the micro tube lamp is 6 nm to 12 mm or so, and when it is too thick, high voltage is required for initiation.

Discharge mode which can be used may be any one of dielectric barrier discharge and electrodeless field discharge. As for the shape of the electrode, a surface in contact with the lamp may be a flat surface. However, when it has a shape corresponding to curvature of the lamp, not only the lamp can be fixed strongly but also more stable discharge is obtained as the electrode is in close contact with the lamp. Further, when the curved space is made of aluminum to have a mirror surface, it can be also a light reflector.

In the present invention, examples of the preferred radiation source include an excimer radiator having maximum radiation at about 172 nm (for example, Xe excimer lamp), a low pressure mercury vapor lamp having a bright line at about 185 nm, a medium pressure and high pressure mercury vapor lamp having wavelength component of 230 nm or lower, and an excimer lamp having maximum radiation at about 222 nm.

Among them, the Xe excimer lamp radiates ultraviolet ray with single wavelength, that is, short wavelength of 172 nm, and thus the radiation efficiency is excellent. As the light has a high oxygen absorption coefficient, radical oxygen atom species or ozone can be generated even with a tiny amount of oxygen.

Further, the light with short wavelength of 172 nm is known to have a high ability of dissociating bonds in an organic compound. Due to high energy of active oxygen or ozone and ultraviolet radiation, the modification of polysilazane layer can be achieved within a short time.

Thus, compared to a low pressure mercury lamp having emission from wavelength of 185 nm, 254 nm or plasma cleaning, it enables shortening of time for the processing accompanied with high through-put or decreasing an area for facilities, and irradiation onto an organic material, a plastic substrate, or the like that are prone to suffer from damages caused by heat.

Further, action of UV light not containing wavelength components of 180 nm or lower from the low pressure mercury lamp from wavelength of 185 nm, 254 nm (HgLP lamp) (185 nm, 254 nm) or KrCl* excimer lamp (222 nm) is limited to direct photodegradation of Si-N bond, and thus it does not generate an oxygen radical or a hydroxyl radical. In such case, as the absorption is negligible enough to be ignored, limitation regarding concentration of oxygen or water vapor is not required. Another advantage of light with shorter wavelength is that it has bigger depth of penetration into a polysilazane layer.

As the excimer lamp has high efficiency of light generation, it is possible to have lighting only with low voltage. Further, as light with long wavelength, which can be a cause of temperature increase by light, is not generated and energy is generated from a single wavelength in an ultraviolet region, it has a characteristic that surface temperature increase in the subject for degradation is suppressed. For such reasons, it is suitable for a flexible film material like PET which is believed to be easily affected by heat.

(Oxygen concentration during vacuum ultraviolet ray (VUV) radiation)

Oxygen is required for the reaction by ultraviolet ray irradiation. However, as vacuum ultraviolet ray has absorption by oxygen, efficiency may be easily lowered during vacuum ultraviolet ray irradiation. Thus, vacuum ultraviolet ray irradiation is preferably carried out in a state in which oxygen concentration is as low as possible.

Oxygen concentration during vacuum ultraviolet ray (VUV) irradiation according to the present invention is preferably 10 to 10,000 ppm (1%), and more preferably 50 to 5,000 ppm.

Dry inert gas is preferred as a gas satisfying the irradiation atmosphere used for vacuum ultraviolet ray irradiation. In particular, dry nitrogen gas is preferred from the viewpoint of cost, in particular. Adjustment of oxygen concentration can be achieved by changing flow amount ratio after measuring flow amount of oxygen gas and inert gas that are introduced to an irradiation cabin.

[Overcoat layer]

An overcoat layer may be formed on a gas barrier layer of the present invention.

(Material to be used for overcoat layer)

Preferably usable examples of an organic material to be used for an overcoat layer include organic resins such as organic monomers, oligomers, and polymers. These organic resins each preferably have a polymerizable group or a crosslinking group, and a layer formed via coating of an organic resin composition coating liquid containing the organic resin, and a polymerization initiator and a crosslinking agent, if desired, is preferably subj ected to a light exposure treatment or a heat treatment for curing. Herein, a "crosslinking group" means a group capable of crosslinking a binder polymer via chemical reaction produced by a light exposure treatment or a heat treatment. The chemical structure is not specifically limited, as long as the group is one exhibiting such a function, but examples of an additionally polymerizable functional group include an ethylenically unsaturated group and a cyclic ether group like an epoxy group/an oxetanyl group. Further, it may be a functional group capable of being radical via light exposure, and examples of such a crosslinking group include a thiol group, a halogen atom, and an onium salt structure. Among these, an ethylenically unsaturated group is preferable, and it includes a functional group described in paragraphs [0130] to [0139] of Japanese Unexamined Publication No. 2007-17948.

Elasticmodulus of the overcoat layer can be adjusted to the desired value by appropriately adjusting a structure of an organic resin, a density of a polymerizable group, a density of the crosslinking group, a ratio of the crosslinking agent, a curing condition and so forth.

Specific examples of the organic resin composition include a resin composition containing an acrylate compound which has a radical reactive unsaturated compound, a resin composition containing an acrylate compound and a mercapto compound which has a thiol compound, and a resin composition in which a polyfunctional acrylate monomer such as epoxy acrylate, urethane acrylate, polyester acrylate, polyether acrylate, and polyethylene glycol acrylate, glycerol methacrylate is dissolved. Further, any mixture of the above-described resin compositions is possible to be used, and the present invention is not limited thereto, as long as it is a photosensitive resin containing a reactive monomer possessing at least one photopolymerizable unsaturated bond in the molecule.

Examples of the reactive monomer having at least one photopolymerizable unsaturated bond in the molecule include methylacrylate, ethylacrylate, n-propylacrylate, isopropylacrylate, n-butylacrylate, isobutylacrylate, tert-butylacrylate, n-pentylacrylate, n-hexylacrylate, 2-ethylhexylacrylate, n-octylacrylate, n-decylacrylate, hydroxyethylacrylate, hydroxypropylacrylate, allylacrylate, benzylacrylate, butoxyethylacrylate, butoxyethylene glycolacrylate, cyclohexylacrylate, dicyclopentanylacrylate, 2-ethylhexylacrylate, glycerol acrylate, glycidyl acrylate, 2-hydroxyethylacrylate, 2-hydroxypropylacrylate, isobonylacrylate, isodexsilacrylate, isooctylacrylate, laurylacrylate, 2-methoxyethylacrylate, methoxyethylene glycolacrylate, phonoxyethylacrylate, stearylacrylate, ethylene glycol acrylate, diethylene glycol diacrylate, 1,4-buthane diol diacrylate, 1,5-pentane diol diacrylate, 1,6-hexane diol diacrylate, 1,3-propane diol acrylate, 1, 4-cyclohexane diol diacrylate, 2,2-dimethylol propane diacrylate, glycerol diacrylate, tripropylene glycol diacrylate, glycerol triacrylate, trimethylol propane triacrylate, polyoxyethyltrimethylol propane triacrylate, pentaerythritol triacrylate, pentaerythritol tetraacrylate, ethylene oxide modified pentaerythritol triacrylate, ethylene oxide modified pentaerythritol tetraacrylate, propionoxide modified pentaerythritol triacrylate, propionoxide modified pentaerythritol tetraacrylate, triethylene glycol diacrylate, polyoxypropylenetrimethylol propane triacrylate, butylenes glycol diacrylate, 1,2,4-butane diol triacrylate, 2, 2, 4-trimethyl-1, 3-pentadiol diacrylate, dialkyl fumarate, 1,10-decane diol dimethyl acrylate, pentaerythritol hexaacrylate, those in which the above-described acrylate is replaced by methacrylate, $\gamma$-methacryloxypropyltrimethoxy silane, and 1-vinyl-2-pyrrolidone. The above-described reactive monomers may be used singly, or in combination with at least two kinds as a mixture. They may be also used as a mixture in combination with a compound other than those described above.

The composition of the foregoing photosensitive resin contains a photopolymerization initiator. Examples of the photopolymerization initiator include benzophenone, o-benzoyl methyl benzoate, 4,4-bis(dimethyl amine)benzophenone, 4,4-bis(diethyl amine)benzophenone, $\alpha$-amino acetophenone, 4,4-dichlorobenzophenone, 4-benzoyl-4-methyldiphenyl ketone, dibenzil ketone, fluorenone, 2,2-diethoxy acetophenone, 2,2-dimethoxy-2-phenyl acetophenone, 2-hydroxy-2-methylpropiophenone, p-tert-butyldichloroacetophenone, thioxanthone, 2-methyl thioxanthone, 2-chloro thioxanthone, 2-isopropyl thioxanthone, diethyl thioxanthone, benzildimethyl ketal, benzylmethoxyethyl acetal, benzoinmethyl ether, benzoinbutyl ether, anthraquinone, 2-tert-butyl anthraquinone, 2-amyl anthraquinone, $\beta$-chloranthraquinone, anthrone, benzanthrone, dibenzsuberon, methylene anthrone, 4-azidobenzil acetophenone, 2,6-bis(p-azidobenzylidene)cyclohexane, 2,6-bis(p-azidobenzylidene)-4-methylcyclohexane, 2-phenyl-1,2-butadiene-2-(o-methoxycarbonyl)oxime, 1-phenyl-propanedione-2-(o-methoxycarbonyl)oxime, 1-phenyl-propanedione-2-(o-ethoxycarbonyl) oxime, 1,3-diphenyl-propanetrione-2-(o-ethoxycarbonyl)oxime, 1-phenyl-3-ethoxy-propanetrione-2-(o-benzoyl)oxime, michler ketone, 2-methyl[4-(methylthio)phenyl]-2-monopholino-1-propane, 2-benzil-2-dimethylamino-1-(4-monopholinophenyl)-butane-1,naphthalenesulfonylchloride,quinolinesulfonyl chloride, n-phenylthioacridone, 4,4-azobisisobutyronitrile, diphenyl disulfide, benzothiazole disulfide, triphenyl phosphine, camphor quinone, carbon tetrabromide,tribromophenylsulfone, benzoin peroxide, eosin, those in which a photo-reducing dye such as methylene blue is used in combination with a reducing agent such an ascorbic acid, triethanol amine or the like. These photopolymerization initiators may be used singly, or in combination with at least two kinds thereof.

An organic material can be contained in an overcoat layer. Elastic modulus of the overcoat layer is to be increased generally by containing the inorganic material. Elastic modulus of the overcoat layer can be adjusted to the desired value by appropriately adjusting a content ratio of the inorganic material.

As for the inorganic material, preferable are inorganic particles having a number average particle diameter of 1 to 200 nm, and more preferable are inorganic particles having a number average particle diameter of 3 to 100 nm. The inorganic particles are preferably made of metal oxide in view of transparency.

The metal oxide is not specifically limited, and examples thereof include $SiO_2$, $Al_2O_3$, $TiO_2$, $ZrO_2$, ZnO, $SnO_2$, $In_2O_3$, BaO, SrO, CaO, MgO, $VO_2$, $V_2O_5$, $CrO_2$, $MoO_2$, $MoO_3$, $MnO_2$, $Mn_2O_3$, $WO_3$, $LiMn_2O_4$, $Cd_2SnO_4$, $CdIn_2O_4$, $Zn_2SnO_4$, $ZnSnO_3$, $Zn_2In_2O_5$, $Cd_2SnO_4$, $CdIn_2O_4$, $Zn_2SnO_4$, $ZnSnO_3$, and $Zn_2In_2O_5$. These may be used singly, or in combination with at least two kinds thereof.

It may be adjusted in the track of recent scientific papers to obtain a dispersion of inorganic particles, but a commercially available inorganic particle dispersion is also preferably usable.

Specific examples thereof include various metal oxide dispersions such as Snowtex series and Organosilica sol produced by Nissan Chemical Industries, Ltd., NANOBYK series produced by BYK Japan KK, and NanoDur produced by Nanophase Technologies Corporation.

These inorganic particles having been subjected to a surface treatment are also usable.

Usable examples of inorganic material include plate-shaped particles such as mica selected from natural mica, or synthetic mica; talc represented by Formula 3: $MgO{\cdot}4SiO{\cdot}H_2O$, teniolite; montmorillonite; saponite; hectorite; and zirconium phosphate.

Specific examples of the above-described natural mica include white mica, soda mica, brown mica, black mica and lepidolite. Further, examples of the synthetic mica include nonswelling mica such as fluoride brown mica {for example, $KMg_3$ $(AlSi_3O_{10})F_2$} and potassium fluosilicate {for example, $KMg_{2.5}(Si_4O_{10})F_2$ or the like}; and swelling mica such as Na tetrasilylic mica (for example, $NaMg_{2.5}(Si_4O_{10})F_2$, Na taeniolite (Na, Li) $Mg_2Li$ $(Si_4O_{10})$ $F_2$ or Li taeniolite (Na, Li) $Mg_2Li$ $(Si_4O_{10})F_2$) and a montmorillonite type (for example, Na hectorite $(Na, Li)_{1/8}Mg_{2/5}Li_{1/8}(Si_4O_{10})$ $F_2$ or Li hectorite $(Na, Li)_{1/8}Mg_{2/5}Li_{1/8}(Si_4O_{10})F_2$). Further, synthetic smectite is also usable.

An inorganic material in an overcoat layer preferably is in the range of 10 to 95% by weight, based on the total weight of the overcoat layer, and more preferably is in the range of 20 to 90% by weight.

For an overcoat layer, a so-called coupling agent may be used either singly or in combination with other materials. Examples of the coupling agent include a silane coupling agent, a titanate coupling agent, and an aluminate coupling agent, but not particularly limited thereto. From the viewpoint of stability of the coating liquid, a silane coupling agent is preferable.

Specific examples of the silane coupling agent include a halogen-containing silane coupling agent (2-chloroethyltrimethoxysilane, 2-chloroethyltriethoxysilane, 3-chloropropyltrimethoxysilane, 3-chloropropyltriethoxysilane or the like), an epoxy group-containing silane coupling agent [2-(3,4-epoxycyclohexyl)ethyltrimethoxysilane, 2-(3,4-epoxycyclohexyl)ethyltriethoxysilane, 3-(3,4-epoxycyclohexyl)propyltrimethoxysilane, 2-glycidyloxyethyltrimethoxysilane, 2-glycidyloxyethyltriethoxysilane, 3-glycidyloxypropyltrimethoxysilane, 3-glycidyloxypropyltriethoxysilane or the like], an amino group-containing silane coupling agent (2-aminoethyltrimethoxysilane, 3-aminopropyltrimethoxysilane, 3-aminopropyltriethoxysilane, 2-[N-(2-aminoethyl)amino]ethyltrimethoxysilane, 3-[N-(2-aminoethyl)amino]propyltrimethoxysilane, 3-(2-aminoethyl)amino]propyltriethoxysilane, 3-[N-(2-aminoethyl)amino]propyl methyl dimethoxysilane or the like), a mercapto group-containing silane coupling agent (2-mercaptoethyltrimethoxysilane, 3-mercaptopropyltrimethoxysilane, 3-mercaptopropyltriethoxysilane or the like), a vinyl group-containing silane coupling agent (vinyltrimethoxysilane, vinyltriethoxysilane or the like), and a (meth)acryloyl group-containing silane coupling agent (2-methacryloyloxyethyltrimethoxysilane, 2-methacryloyloxyethyltriethoxysilane, 2-acryloyloxyethyltrimethoxysilane, 3-methacryloyloxypropyltrimethoxysilane, 3-methacryloyloxypropyltriethoxysilane, 3-acryloyloxypropyltrimethoxysilane or the like). The silane coupling agent may be used either singly or in combination with at least two kinds thereof.

The overcoat layer is preferably formed by mixing the foregoing organic resin or inorganic material, and another component, if desired, and applying a coating liquid on the surface of a substrate by a conventionally known conventional coating method after preparation thereof as a coating liquid employing a diluted solvent appropriately used if desired, and curing the coating liquid by ionizing radiation. Meanwhile, as a method for irradiating ionizing radiation, it is conducted by delivering ultraviolet radiation having a wavelength range of 100 to 400 nm, and preferably a wavelength range of 200 to 400 nm emitted from an ultrahigh pressure mercury lamp, a high pressure mercury lamp, a low pressure mercury lamp, a carbon-arc lamp, a metal halide lamp or the like, or by delivering electron beam having a wavelength range of 100 nm or less emitted from a scanning type or curtain type electron beam accelerator.

«Applications of gas barrier film»

Gas barrier films of the present invention are applicable mainly for package of electronic devices and so forth, or for gas barrier films used for display material such as an organic EL element, a solar cell, and a plastic substrate provided for liquid crystal, and for resin substrates used for various devices in which a gas barrier film is provided and various device elements.
The gas barrier film of the present invention is preferably applicable for various sealing materials and films.
An organic photoelectric conversion element is described as an example of an electronic device equipped with the gas barrier film of the present invention.

(Organic photoelectric conversion element)

The organic photoelectric conversion element of the present invention possesses a gas barrier film of the present invention, but when the gas barrier film is utilized in the organic photoelectric conversion element, it is preferably transparent, and this gas barrier film can be designed to be used as a substrate (referred to also as a support) so as to receive sunlight from this side.
That is, a transparent conductive thin film such as ITO or the like as a transparent electrode, for example, is provided on the gas barrier film of the present invention to constitute a resin support used for the organic photoelectric conversion element.
Then, an ITO transparent conductive film provided on a resin support for the organic photoelectric conversion element is used as an anode; a porous semiconductor layer is provided on this anode; and a cathode composed of a metal film is further formed to produce the organic photoelectric conversion element. Another sealing material (the same material is also allowed to be used) is layered on this element, and the foregoing gas barrier film support adheres to circumference thereof to seal the element. Thus, the organic photoelectric conversion element can be sealed. As a result, the influences of water vapor of outside air and gas such as oxygen on the element can be suppressed.
A transparent conductive film is formed on a ceramic layer as a gas barrier film prepared in this way to obtain a resin support for the organic photoelectric conversion element (herein, the ceramic layer may indicate a silicon oxide layer formed via a modifying treatment of a polysilazane layer).
A transparent conductive film can be formed by a vacuum vapor deposition method, a sputtering method or the like, and also prepared by a coating method such as a sol-gel method employing metal alkoxide of indium, tin or the like.
Further, the range of the transparent conductive film thickness is preferably 0.1 to 1,000 nm.
Next, each of organic photoelectric conversion element material layers (constituting layers) constituting the organic photoelectric conversion element is described.

(Configuration of organic photoelectric conversion element and solar cell)

Preferred embodiments of the organic photoelectric conversion element and a solar cell are described. In addition, preferred embodiments of the organic photoelectric conversion element will be described below, but the solar cell possesses the organic photoelectric conversion element as a constituent, and further, a preferred structure of the solar cell can be similarly described.
The organic photoelectric conversion element is not specifically limited, and may be an element of generating electric current via light-irradiation, in which an anode, a cathode, and at least one power generation layer (referred to also as a layer in which a p-type semiconductor and an n-type semiconductor are mixed; a bulk heterojunction layer; or an i layer) sandwiched between the anode and the cathode are provided.
Preferred specific examples of layer configuration for the organic photoelectric conversion element is described below (desirable layer configuration for the solar cell is also identical to the layer configuration for the organic photoelectric conversion element).
Preferred specific examples of layer configuration for the organic photoelectric conversion element is described below.

(i) anode/power generation layer/cathode
(ii) anode/hole transport layer/power generation layer/cathode
(iii) anode/hole transport layer/power generation layer/electron transport layer/cathode
(iv) anode/hole transport layer/p-type semiconductor layer/power generation layer/n-type semiconductor layer/electron transport layer/cathode, and
(v) anode/hole transport layer/first power generation layer/electron transport layer/intermediate electrode/hole transport layer/second power generation layer/electron transport layer/cathode.

Herein, a power generation layer should contain a p-type semiconductor material capable of transporting holes and an n-type semiconductor material capable of transporting electrons. These may be substantially two layers to produce heterojunction, or bulk heterojunction in the state where these are mixed in the inside of a single layer may be prepared, but the bulk heterojunction configuration is preferable since photoelectric conversion efficiency is high. The p-type semiconductor material and the n-type semiconductor material used for a power generation layer will be hereinafter described.

Since similarly to an organic EL element, extraction efficiency of holes and electrons into anode/cathode can be increased by sandwiching a power generation layer with a hole transport layer and an electron transport layer, configuration ((ii) or (iii)) having such a structure is preferable. Further, since the power generation layer itself enhances rectification of holes and electrons (selectivity to extract carrier), configuration (iv) in which the power generation layer is sandwiched by a layer formed of the p-type semiconductor material and formed of the n-type semiconductor material (referred to also as "p-i-n configuration") may be used. Further, in order to increase sunlight-use efficiency, tandem configuration (configuration (v)) in which sunlight having different wavelengths is absorbed by each of power generation layers may be also used.

Next, material constituting each of these layers is described.

(Organic photoelectric conversion element material)

Material used for formation of a power generation layer (referred to also as "photoelectric conversion layer") in the organic photoelectric conversion element is described.

<p-type semiconductor material>

As the p-type semiconductor material preferably used as a power generation layer (a bulk heterojunction layer) in the organic photoelectric conversion element, cited are various types of condensed polycyclic aromatic low-molecular weight compounds, and conjugated polymers and oligomers.

Examples of the condensed polycyclic aromatic low molecular weight compounds include: anthracene, tetracene, pentacene, hexacene, heptacene, chrysene, picene, fulminene, pyrene, peropyrene, perylene, terylene, quoterylene, coronene, ovalene, circumanthracene, bisanthene, zethrene, heptazethrene, pyranthrene, violanthene, isoviolanthene, circobiphenyl, anthradithiophene; porphyrin, copper phthalocyanine; tetrathiafulvalene (TTF)-tetracyanoquinodimethane (TCNQ) complex, bisethylenetetrathiafulvalene (BEDTTTF)-perchloric acid complex; and a derivative or a precursor thereof.

Further, examples of a derivative containing the condensed polycyclic structure include pentacene derivatives having a substituent disclosed in WO 03/16599 A, WO 03/28125 A, U.S. Patent No. 6,690,029, and Japanese Unexamined Publication No. 2004-107216; pentacene precursors disclosed in US Patent Application Publication No. 2003/136964; substituted acenes and their derivatives disclosed in J. Amer. Chem. Soc., vol. 127. No. 14, 4986, J. Amer. Chem. Soc., vol. 123, p 9482, and J. Amer. Chem. Soc., vol. 130 (2008), No. 9, 2706, and the like.

Examples of a conjugated polymer include polythiophene such as poly 3-hexylthiohene (P3HT) and its oligomer, polythiophene having a polymerizable group disclosed in Technical Digest of the International PVSEC-17, Fukuoka, Japan, 2007, p.1225, polythiophene-thienophene copolymer disclosed in Nature Material, Vol. 5, p. 328 (2006), polythiophene-diketopyrrolopyrrole copolymer disclosed in literature of WO2008/000664, polythiophene-thizolothiazole copolymer disclosed in Adv. Mat., p.4160 (2007), polythiophene copolymer like PCPDTBT disclosed in Nature Material, Vol. 6, p. 497 (2007), polypyrrole and its oligomer, polyaniline, polyphenylene and its oligomer, polyphenylene vinylene and its oligomer, polythienylene vinylene and its oligomer, polyacetylene, polydiacetylene, polysilane, and a $\sigma$ conjugated polymers such as polygerman.

Suitably usable oligomers other than polymers are oligomers such as: $\alpha$-sexithionene, $\alpha,\omega$-dihexyl-$\alpha$-sexithionene, $\alpha,\omega$-dihexyl-$\alpha$-quinquethionene, $\alpha,\omega$-bis(3-butoxypropyl)-sexithionene, and so forth as thiophene hexamers.

Among these compounds, preferable are compounds exhibiting high solubility into an organic solvent to such an extent that a solution process is able to be possibly conduced, and those capable of achieving high mobility by forming a crystalline thin film after drying.

When an electron transport layer is formed on a power generation layer via a coating process, since there is a problem that an electron transport layer solution may dissolve the power generation layer, a material capable of being insoluble after conducting coating by a solution process may be used.

Examples of such a material include a material insoluble via crosslinking polymerization of a coating film after coating, like thiophene having a polymerizable group which is described in Technical Digest of the International PVSEC-17, Fukuoka, Japan, 2007, p.1225; and a material in which a soluble substituent produces insolubility via reaction (being made into a pigment) by applying energy such as heat or the like as described in the specification of US Patent Application Publication No. 2003/136964 and Japanese Unexamined Publication No. 2008-16834.

<n-Type semiconductor material>

There is no specific limitation to an n-type semiconductor material used in the bulk heterojunction layer, but examples thereof include fullerene, octaazaporphyrin or the like, a perfluoro compound in which a hydrogen atom in a p-type semiconductor is replaced by a fluorine atom (perfluoropentacene, perfluorophthalocyanine and so forth), aromatic carboxylic acid anhydride such as naphthalene tetracarboxylic anhydride, naphthalene tetracarboxylic diimide, perylene tetracarboxylic anhydride, and perylene tetracarboxylic acid diimide, and a polymeric compound possessing an imide compound thereof as a skeleton.

However, preferable is a fullerene derivative capable of effectively conducting charge separation with each of various n-type semiconductor materials at a high speed (to 50 fs). Examples of a fullerene derivative include: fullerene C60, fullerene C70, fullerene C76, fullerene C78, fullerene C84, fullerene C240, fullerene C540, mixed fullerene, fullerene nano-tube, multi-layer nano-tube, mono layer nano-tube, and nano-horn (cone type) and a fullerene derivative a part of which is substituted with a hydrogen atom, a halogen atom, a substituted or unsubstituted alkyl group, an alkenyl group, an alkynyl group, an aryl group, a heteroaryl group, a cycloalkyl group, a silyl group, an ether group, a thioether group, an amino group, a silyl group, or the like.

Among these, preferably usable examples include [6, 6] -phenyl C61-butyric acid methyl ester (abbreviated name PCBM), [6, 6]-phenyl C61-butyric acid n-butyl ester (PCBnB), [6,6]-phenyl C61-butyric acid isobutyl ester (PCBiB), [6, 6]-phenyl C61-butyric acid n-hexyl ester (PCBH), bis-PCBM disclosed in Adv. Mater., vol. 20 (2008), p.2116, aminated fullerene disclosed in Japanese Unexamined Publication No. 2006-199674, metallocene fullerene disclosed in Japanese Unexamined Publication No. 2008-130889, and a fullerene derivative which has improved solubility by possessing a substituent such as fullerene containing a cyclic ether group, disclosed in the specification of U.S. Patent No. 7, 329, 709.

(Hole transport layer/electron block layer)

The organic photoelectric conversion element of the present invention possesses a hole transport layer provided between a bulk heterojunction layer and an anode, and preferably possesses these layers since charge generated in the bulk heterojunction layer is possible to be more effectively extracted.

Usable examples of material constituting each of these layers for a hole transport layer include PEDOT (poly-3,4-ethylenedioxythiopehen), PEDOR/PSS (polyethylene dioxythiophene polystyrene sulfonate; product name: Baytron P; produced by Bayer); polyaniline and doped material thereof; a cyan compound disclosed in WO 06/19270.

In addition, an electron-blocking function having a rectification effect by which electrons generated in a bulk heterojunction layer are not flowed on the anode side is provided for a hole transport layer having a shallower LUMO level than an LUMO level of an n-type semiconductor material used for a bulk heterojunction layer.

Such a hole transport layer is also called an electron block layer, and it is preferable that a hole transport layer having such a function is used. Usable examples of material thereof include a triarylamine based compound disclosed in Japanese Unexamined Publication No. 5-271166, and metal oxide such as molybdenum oxide, nickel oxide, and tungsten oxide.

Further, usable is a layer which is made only of a p-type semiconductor material used for a bulk heteroj unction layer. As a method to prepare these layers, any of a vacuum vapor deposition method and a solution coating method is allowed to be used, but the solution coating method is preferable. When a coating layer is prepared as a lower layer before preparing a bulk heterojunction layer, there is an effect by which the coating surface is leveled, and influence caused by leakage and so forth is preferably reduced, and therefore preferable.

(Electron transport layer/hole block layer)

An organic photoelectric conversion element of the present invention possesses an electron transport layer provided between a bulk heterojunction layer and a cathode, and preferably possesses these layers since charge generated in the bulk heterojunction layer is possible to be more effectively extracted.

Further, usable examples of the electron transport layer include octaazaporphyrin, and a perfluoro substance of a p-type semiconductor (perfluoropentacene, perfluorophthalocyanine and so forth), but a hole-blocking function having a rectification effect by which holes generated in a bulk heterojunction layer are not flowed on the cathode side is similarly provided for an electron transport layer having a deeper HOMO level than an HOMO level of a p-type semiconductor material used for a bulk heterojunction layer.

Such an electron transport layer is also called a hole block layer, and it is preferable that an electron transport layer having such a function is used.

Usable examples of material thereof include a phenanthrene based compound such as bathocuproine; n-type semiconductor material such as naphthalene tetracarboxylic acid anhydride, naphthalene tetracarboxylic acid diimide, perylene tetracarboxylic acid anhydride, and perylene tetracarboxylic acid diimide; n-type inorganic oxide such as titanium

oxide, zinc oxide, and gallium oxide; an alkali metal compound such as lithium fluoride, sodium fluoride, and cesium fluoride.

Further, usable is a layer which is made only of an n-type semiconductor material used for a bulk heterojunction layer. As a method to prepare these layers, any of a vacuum vapor deposition method and a solution coating method is used, but the solution coating method is preferable.

(Other layers)

In order to improve energy conversion efficiency, or to improve element lifetime, the configuration in which various intermediate layers are provided in an element may be used. Examples of the intermediate layer include a hole block layer, an electron block layer, a hole injection layer, an electron injection layer, an exciton block layer, a UV absorbing layer, a light reflection layer, and a wavelength conversion layer.

(Transparent electrode (first electrode))

A transparent electrode as a cathode or an anode is not particularly limited, and can be selected depending on element configuration, but the transparent electrode is preferably used as an anode. When being used as an anode, it is preferably an electrode transmitting light having a wavelength of 380 to 800 nm.

Usable examples of material include transparent conductive metal oxide such as indium tin oxide (ITO), $SnO_2$, and ZnO, a metal thin film formed of gold, silver, platinum or the like, metal nanowire, and carbon nanotube.

Also usable are a conductive polymer selected from the group consisting of derivatives of polypyrrole, polyaniline, polythiophene, polythienylene vinylene, polyazulene, polyisothianaphthene, polycarbazole, polyacetylene, polyphenylene, polyphenylene vinylene, polyacene, polyphenylacetylene, polydiacetylene and polynaphthalene. Further, these conductive compounds may be also used in combination to produce a transparent electrode.

(Counter electrode (second electrode))

The counter electrodemaybe a single layer as a conductive material layer, but in addition to a material exhibiting conductivity, a resin to support this material may be used in combination. As a conductive material used for a counter electrode, those containing metal, alloy, an electric conductive compound, and a mixture thereof having a small work function (that is, the same or less than 4 eV) as an electrode material are used.

Specific examples of such an electrode material include sodium, a sodium potassium alloy, magnesium, lithium, a magnesium/copper mixture, a magnesium/silver mixture, a magnesium/aluminum mixture, a magnesium/indium mixture, an aluminum/aluminum oxide ($Al_2O_3$) mixture, indium, a lithium/aluminum mixture, and a rare earth metal.

Among these, from the viewpoint of electron extraction performance and resistance to oxidation, preferable is a mixture of each of these metals and the second metal as a stable metal having a larger work function than that of the foregoingmetal such as amagnesium/silvermixture, a magnesium/aluminum mixture, a magnesium/indium mixture, an aluminum/aluminum oxide ($Al_2O_3$) mixture, and a lithium/aluminum mixture.

A thin film as a counter electrode can be prepared via vapor deposition or sputtering of this electrode material. Further, the film thickness is generally selected from the range of 10 nm to 5 $\mu$m, and preferably selected from the range of 50 to 200 nm.

When a metallic material is used as a conducting material for a counter electrode, light transmitted at the counter electrode side to be reflected is reflected on the first electrode side, and this light is possible to be reused, and absorbed again in the photoelectric conversion layer, whereby photoelectric conversion efficiency is improved, and therefore preferable.

Further, a counter electrode may be formed of metal (for example, gold, silver, copper, platinum, rhodium, ruthenium, aluminum, magnesium and indium), or of nano particles, nanowires or a nano structure material, made of carbon. When it is a dispersion of nanowires, it is preferable that a transparent counter electrode exhibiting high conductivity can be prepared by a coating method, and therefore preferable.

When making the counter electrode side to be light-transparent, a light-transparent counter electrode can be made by providing a layer formed of a conductive light-transparent material cited in the description of the above-described transparent electrode,after preparing a film made of a conductive material suitable for a counter electrode such as aluminum, aluminumalloy, silver, and a silver compound, which has a film thickness of about 1 to 20 nm.

(Intermediate electrode)

Further, a material constituting an intermediate electrode used in the case of tandem configuration like layer configuration (v) of the foregoing organic photoelectric conversion element is preferably a layer in which a compound

exhibiting both transparency and conductivity at the same time is used, and usable examples include the material used for the foregoing transparent electrode (for example, transparent metal oxide like ITO, AZO, FTO, titanium oxide or the like, a very thin metal layer made of Ag, Al, Au or the like, a material constituting a layer containing nanoparticles nanowires, PEDOT:PSS, conductive polymeric material such as polyaniline).

In addition, among the foregoing hole transport layers and electron transport layers, layers appropriately laminated in combination are also those used in combination, which serve as an intermediate electrode (charge recombination layer), and it is preferable that a step of preparing a layer can be omitted by using such a structure.

(Metal nanowire)

Usable examples of conductive fiber include metal-coated organic or inorganic fiber, conductive metal oxide fiber, metal nanowire, carbon fiber, and carbon nanotube, but metal nanowire is preferable.

The metal nanowire generally means a linear structure made from metal elements as main constituting elements. Specifically, the metal nanowire of the present inventionmeans a linear structure having a diameter of several nanometers.

The metal nanowire preferably has a mean length of 3 μm or more, more preferably has a mean length of 3 μm to 500 μm, and particularly preferably 3 μm to 300 μm in order to prepare a long conductive path with a single metal nanowire, and to exhibit appropriate light scattering performance. In addition, the length preferably has a relative standard deviation of 40% or less.

Further, the average diameter is small in view of transparency, and on the other hand, it is large in view of conductivity. In the present invention, the metal nanowire preferably has an average diameter of 10 nm to 300 nm, and more preferably has an average diameter of 30 nm to 200 nm. In addition, the diameter preferably has a relative standard deviation of 20% or less.

The metal composition of the metal nanowire is not specifically limited, and can be composed of at least one metal as a noble metal element or less noble metal element, but preferably contains at least one metal selected from the group consisting of noble metals (for example, gold, platinum, silver, palladium, rhodium, iridium, ruthenium, osmium and so forth), andiron, cobalt, copper and t in, andmorepreferably contains at least silver in view of conductivity.

Silver and at least one metal selected from noble metals other than silver are also preferably contained in order to have both the conductivity and stability (resistance to sulfuration or oxidation of metal nanowires, and resistance to migration) at the same time. When the metal nanowire of the present invention contains at least two metal elements, for example, the surface and the inside of the metal nanowire may be different from each other in terms of metal composition, and the whole metal nanowire may have the same metal composition.

The manufacturing means of the metal nanowire is not specifically limited, for example, a commonly known means such as a liquid phase method, and a vapor phase method is usable. Further, a specific manufacturing method is not specifically limited either, and a commonly known manufacturing method is usable.

As a method of manufacturing Ag nanowires cited are, for example, Adv. Mater., 2002, 14, 833-837 and Chem. Mater., 2002, 14, 4736-4745. As a method of manufacturing A unanowires cited is Japanese Unexamined Publication No. 2006-233252. As a method of manufacturing Cu nanowires cited is Japanese Unexamined Publication No. 2002-266007. As a method of manufacturing Co nanowires cited is Japanese Unexamined Publication No. 2004-149871. Specifically, in the case of the above-described method of manufacturing Ag nanowires as described in Adv. Mater. and Chem. Mater., Ag nanowires can be prepared simply in an aqueous system, and further, since electrical conductivity of silver is the highest among all metals, it is preferably applicable as a method of manufacturing silver nanowires according to the present invention.

A three-dimensional conductive network is produced by making metal nanowires come into contact with each other to generate high conductivity, and light is possible to pass through a window portion of the conductive network in which no metal nanowire is present. Thus, electric power is possible to be effectively generated from an organic power generation layer section further via the scattering effect of the metal nanowires. When in the first electrode, metal nanowires are provided on the side close to the organic power generation layer section, this is more preferable since this scattering effect is more effectively utilized.

(Optical functional layer)

An organic photoelectric conversion element may possess various optical function layers for the purpose of effectively receiving light from sunlight. As an optical function layer, provided may be, for example, an antireflection layer, a light collecting layer such as microlens array, a light diffusion layer capable of diffusing light reflected at a cathode to be incident on a power generation layer again, and or the like.

Various antireflection layers may be provided as an antireflection layer, but for example, in cases where a transparent resin film is a biaxially stretched polyethylene terephthalate film, it is preferable that an easy adhesion layer adjacent to the film has a refraction index of 1.57 to 1.63 so that transmittance can be improved by reducing interface

reflection between a film substrate and the easy adhesion layer. In order to adjust refraction index, there is a method in which a content ratio of a binder resin to oxide sol exhibiting considerably high refractive index such as tin oxide sol, and cerium oxide sol is appropriately adjusted to conduct a coating process. The easy adhesion layer may be a single layer, but may allowed to be composed of at least two layers in order to improve adhesiveness.

As to the light collecting layer, for example, a processing can be performed to have a structure on a microlens array provided on the sunlight receiving side of a support substrate, or it is used in combination with a so-called light collecting sheet to increase a light receiving amount from the specific direction, whereby in contrast, sunlight incident angle dependency can be reduced.

As an example of the microlens array, pyramids each having 30 μm on a side and an apex angle of 90 degrees on the light extraction side of a substrate are two-dimensionally arrayed. Preferable are 10 to 100 μm on a side. When being smaller than this range, a diffraction effect is generated, whereby tinting thereof is seen, and when exceeding this range, thickness thereof is undesirably thickened.

Further, examples of the light diffusion layer include various antiglare layers, a layer in which nanoparticle · nanowire made of metal or various inorganic oxides, or the like is dispersed in a colorlessly transparent polymer or the like.

(Film formation method · surface treatment method)

Examples of a method of preparing a bulk heterojunction layer in which electron acceptors and electron donors are mixed and a transport layer/electrode include a vapor deposition method and coating methods (including a cast method and a spin coating method). Among these, examples of the method for producing a bulk heterojunction layer include a vapor deposition method and coating methods (including a cast method and a spin coating method).

Among these, a coating method is preferable in order to increase the interfacial area in which the foregoing holes and electrons are charge-separated, and to prepare an element exhibiting high photoelectric conversion efficiency. Further, the coating method has an excellent manufacturing speed.

A coating method employed in this case is not limited, but examples thereof include a spin coating method, a solution casting method, a dip coating method, a blade coating method, a wire bar coating method, a gravure coating method, and a spray coating method. Further, patterning can be also conducted by each of printing methods such as an ink-jet method, a screen printing method, a letterpress printing method, an intaglio printing, an offset printing method, or a flexographic printing method.

Heating is preferably conducted after coating in order to produce mobility improvement and longer wavelength absorption via removal of a residual solvent, moisture content and gas, and crystallization of a semiconductor material. When an annealing treatment is conducted at the predetermined temperature in a manufacturing step, coagulation or crystallization is partially and microscopically accelerated, whereby a bulk heterojunction layer having a suitable phase-separation structure can be realized. As a result, carrier mobility of the bulk heterojunction layer can be improved to obtain high efficiency.

A power generation layer (bulk heterojunction layer) may be composed of a single layer in which electron acceptors and electron donors are evenly mixed, but may be composed of plural layers in which a mixing ratio of electron acceptors to electron donors is changed. In this case, preparation thereof becomes possible when a material capable of being insoluble is used after coating as described above.

(Patterning)

The present invention is not specifically limited to methods and processes of patterning an electrode, a power generation layer, a hole transport layer, an electron transport layer and so forth, and commonly known methods are appropriately applicable.

In the case of a soluble material such as a bulk heterojunction layer, a transport layer and so forth, only undesired portions may be removed after coating the entire surface via die coating, dip coating and or the like, direct patterning may be conducted during coating by using an ink-j et method, a screen printing method or the like.

In the case of an insoluble material such as an electrode material, mask vapor deposition can be conducted during vacuum deposition of an electrode, and pattering can be also conducted by a commonly known method such as etching and lift-off. Further, a pattern having been prepared on another substrate may be transferred to prepare the pattern.

**EXAMPLES**

Hereinbelow, the present invention is described specifically by referring to examples, however, the present invention is not limited to them. In the Examples, the term "parts" or "%" is used. Unless particularly mentioned, this represents "parts by weight" or "% by weight".

Example 1

«Preparation of substrate»

[Preparation of substrate (A)]

By using a polyester film (super-low heat shrinkage PET Q83, produced by Teijin Dupont Films Japan Ltd.) having a thickness of 125 μm, whose surfaces each are subjected to an easy adhesion treatment, as a thermoplastic resin substrate (that is, support), a bleed out protection layer is provided on one surface, and a flat and smooth layer is provided on an opposite surface, and the resultant is used as a substrate (A).

<Formation of bleed out protection layer>

After a UV curable organic/inorganic hybrid hard coat material OPSTAR Z7535 produced by JSR Corporation was coated on one surface of the above-described thermoplastic resin substrate under the condition to have a dry film thickness of 4.0 μm, curing was conducted under the curing conditions including irradiation energy amount of 1.0 J/$cm^2$, air atmosphere, and use of a high pressure mercury lamp; and the drying conditions of 80°C for 3 minutes to form a bleed out protection layer.

<Formation of flat and smooth layer 1>

Subsequently, a UV curable type organic/inorganichybrid hard coating material OPSTAR Z7501, which is produced by JSR Corporation, was coated on a surface opposite to the surface on which the bleed-out preventive layer of the thermoplastic resin substrate is formed, was coated under the condition to have a film thickness of 4.0 μm after drying, followed by drying under the drying conditions of 80°C for 3 minutes, and curing was subsequently conducted under the curing conditions including irradiation energy amount of 1.0 J/$cm^2$, air atmosphere, and use of a high pressure mercury lamp to form the flat and smooth layer 1.

The surface roughness Rz of the resulting flat and smooth layer 1 as measured by the method described in JIS B 0601 (2001) was about 25 nm.

The surface roughness was measured employing an AFM (atomic force microscope) SP13800 NDFM, manufactured by SII Inc. After the first measurement within the range of 80 μm x 80 μm, measurement was conducted three times while changing measurement locations, values of Rz obtained by each measurement were averaged to be designated as a measured value.

[Preparation of substrate (B)]

By using a transparent polyimide film (NEOPRIM L, produced by Mitsubishi Gas Chemical Company, Inc.) having a thickness of 200 μm, whose surfaces each are subjected to an easy adhesion treatment, as a heat resistant substrate, a flat and smooth layer is provided on both surfaces of the substrate, and the resultant is used as a substrate (B).

(Formation of flat and smooth layer 2)

<Preparation of coating liquid for flat and smooth layer 2>

8. 0 g of trimethylol propane triglycidyl ether (EPOLIGHT 100MF, manufactured by KYOEISHA CHEMICAL Co., LTD.), 5.0 g of ethylene glycol glycidyl ether (EPOLIGHT 40E, manufactured by KYOEISHA CHEMICAL Co., LTD.), 12.0 g of silsesquioxane having an oxetanyl group: OX-SQ-H (manufactured by Toagosei Company, Limited), 32.5 g of 3-glycidyoxypropyltrimethoxysilane, 2.2 g of Al (III) acetyl acetonate, 134.0 g of methanol silanol (manufactured by Nissan Chemical Industries, Ltd., solid matter content of 30% by weight), 0.1 g of BYK333 (manufactured by BYK Japan KK, silicone-based surface active agent), 125.0 g of butyl cellosolve, and 15.0 g of 0.1 mol/L aqueous solution of hydrogen chloride were mixed with one another and fully stirred. The resultant was deaerated by keeping it again at room temperature to obtain a coating liquid for a flat and smooth layer.

<Formation of flat and smooth layer 2>

Corona discharge treatment was performed for one surface of the heat resistant substrate according to a standardmethod, the coating liquid for a flat and smooth layer was coated under the condition that film thickness is 4.0 μm after drying, and it was dried for 3 min at 80°C. By performing a heating treatment for 10 min at 120°C, the flat and

smooth layer 2 was formed.

<Formation of flat and smooth layer 3>

The flat and smooth layer 3 was formed on a surface of the heat resistant substrate, which is opposite to the surface on which the smooth and flat layer 2 is formed, in the same manner as the method for forming the flat and smooth layer 2.

The surface roughness Rz of the formed flat and smooth layer 2 and the flat and smooth layer 3 was measured by the method described in JIS B 0601 (2001). As a result, it was about 20 nm in terms of Rz. Meanwhile, the measurement of the surface roughness was performed by using the same method as the method used for preparation of the substrate (A).

[Preparation of substrate (C)]

The substrate (C) was prepared in the same manner as the preparation of the substrate (B) except that SIL PLUS H100 with thickness of 100 μm manufactured by Nippon Steel Chemical Co., Ltd, which is a film having silsesquioxane with an organic and inorganic hybrid structure as a main skeleton, was used as a heat resistant substrate instead of a transparent polyimide film (NEOPRIM L, producedbyMitsubishi Gas Chemical Company, Inc.) having a thickness of 200 μm, whose surfaces each are subjected to an easy adhesion treatment. Meanwhile, as a result of measuring the surface roughness of the flat and smooth layer 2 and the flat and smooth layer 3 by using the same method, Rz was found to be about 20 nm.

«Manufacture of gas barrier film 1 to 11»

According to the types of substrate, layer configuration, and conditions for vacuum ultraviolet ray irradiation shown in Table 1, a gas barrier layer consisting of plural layers was formed by coating formation, and as a result, the gas barrier films 1 to 11 were manufactured. Meanwhile, regarding the layer configuration shown in the table, the gas barrier layer closer to the substrate is described as the first layer.

«Method for forming gas barrier layer»

(Formation of polysilazane layer)

On a substrate as a subject, or a gas barrier layer to be a bottom layer, the following coating liquid containing a polysilazane compound was coated by using a spin coater under the condition allowing that each film thickness after drying corresponds to a pre-determined film thickness. The drying condition includes 2 min at 100°C.

<Preparation of coating liquid containing polysilazane compound>

The coating liquid containing a polysilazane compound was prepared as follows: a dibutyl ether solution containing 20% by weight non-catalytic perhydropolysilazane (AQUAMICA NN120-20, produced by AZ electronic materials Co., Ltd.) and a dibutyl ether solution containing 20% by weight perhydropolysilazane containing a 5% by weight of N,N,N',N'-tetramethyl-1,6-diaminohexane, as an amine catalyst, in solid content (AQUAMICA NAX120-20, produced by AZ electronic materials Co., Ltd.) were mixed to adjust the amine catalyst to 1% by weight (compared to the perhydropolysilazane) in solid content, followed by further diluting with a dibutyl ether solution, if necessary, to prepare the foregoing coating liquid containing polysilazane compound which is a dibutyl ether solution with total solid content of 2% by weight to 20% by weight. They were suitably used according to a pre-determined film thickness of polysilazane layer.

(Vacuum ultraviolet ray irradiation treatment)

A polysilazane coating film was formed as described above, and then by performing a vacuum ultraviolet ray irradiation treatment as described below, each gas barrier layer was formed. Detailed condition for each treatment performed on each layer is described in Table 1. In the table, the oxygen concentration represents oxygen concentration at the time of irradiating vacuum ultraviolet rays by a vacuum ultraviolet ray irradiation process after forming the gas barrier layer. According to control of the concentration, sample stage concentration, or integrated irradiation energy, and also multiple lamination of the polysilazane layer as a thin film, composition of the gas barrier was varied.

<Condition for vacuum ultraviolet ray irradiation and measurement of irradiation energy>

Fig. 1 is a cross-sectional schematic diagram of the apparatus for vacuum ultraviolet ray irradiation. The vacuum ultraviolet ray irradiation was performed by using that apparatus.

In Fig. 1, 1 represents an apparatus chamber, and by supplying a suitable amount of nitrogen and oxygen from a non-illustrated gas inlet to the inside and discharging it through a non-illustrated gas outlet, water vapor is substantially removed from the inside of the chamber so that oxygen concentration can be maintained at a pre-determined concentration. 2 represents a Xe excimer lamp with a double-tubular structure (excimer lamp light intensity: 130 mW/$cm^2$) which irradiates vacuum ultraviolet rays of 172 nm, 3 represents a holder of an examiner lamp, functioning also as an external electrode. 4 represents a sample stage. Sample stage 4 can move back and forth horizontally at a pre-determined speed within the apparatus chamber 1 by a non-illustrated means for transport. Further, sample stage 4 can be maintained at a pre-determined temperature by a non-illustrated heating means. 5 represents a sample with polysilazane compound coating layer formed thereon. Height of the sample stage is adjusted such that, when the sample stage moves horizontally, the shortest distance between coating layer surface on the sample and the tubular surface of the excimer lamp is 3 mm. 6 represents a light shielding plate, and it prevents irradiation of vacuum ultraviolet rays on a coating layer on the sample during aging of a Xe excimer lamp 2.

The energy irradiated on the coating layer surface of the sample by the vacuum ultraviolet ray irradiation process was measured by using a ultraviolet integrated actinometer C8026/H8025 UV POWER METER manufactured by Hamamatsu Photonics K. K. and a sensor head of 172 nm. For the measurement, the sensor head was set at the center of the sample stage 4 such that the shortest distance between the tubular surface of the Xe excimer lamp and the measurement surface of the sensor head is 3 mm. Further, nitrogen and oxygen were fed such that the atmosphere inside the apparatus chamber 1 has the same oxygen concentration as the vacuum ultraviolet ray irradiation process and the sample stage 4 was moved at the rate of 0.5 m/min to perform the measurement. Before the measurement, to stabilize the illuminance of the Xe excimer lamp 2, aging time of 10 min was allowed after lighting the Xe excimer lamp. After that, by moving the sample stage, the measurement was initiated.

Based on the irradiation energy obtained from the above measurement, an adjustment was made to have the irradiation energy shown in Table 1 by adjusting the movement rate of the sample stage. Meanwhile, for the vacuum ultraviolet ray irradiation, it was performed after aging time of 10 min, similar to the measurement of irradiation energy.

«Manufacture of comparative gas barrier films 12 and 13»

[Manufacture of gas barrier film 12]

By using a vacuum plasma CVD apparatus, a gas barrier layer was formed as a first barrier layer was formed on a surface of the flat and smooth layer of the substrate (A). The frequency of the high frequency power source used at this time was 27.12 MHz and the distance between the electrodes was set to be 20 mm. As raw material gases, there were introduced a silane gas with a flow rate of 7.5 sccm, an ammonia gas with a flow rate of 50 sccm, and a hydrogen gas with a flow rate of 200 sccm in a vacuum chamber. Subsequently, at the starting time of film formation, the temperature of the film substrate was set to 100°C and the gas pressure was set to 30 Pa during film formation, and thus a gas barrier layer containing silicon nitride as a main component was formed with a thickness of 100 nm. As a result, the gas barrier film 12 was obtained.

[Manufacture of gas barrier film 13]

The gas barrier film 13 was obtained in the same manner as the gas barrier film 12 except that as raw material gases, there were introduced a silane gas with a flow rate of 7.5 sccm, an ammonia gas with a flow rate of 100 sccm, and a nitrous oxide gas with a flow rate of 50 sccm in a vacuum chamber, subsequently, at the starting time of film formation, the temperature of the film substrate was set to 100°C and the gas pressure was set to 100 Pa during film formation, and thus a gas barrier layer containing silicon oxynitride as a main component was formed with a thickness of 200 nm.

[Table 1]

| Gas barrier film No. | Type of substrate | Conditions for coating of gas barrier layer and vacuum ultraviolet ray irradiation process | | | | | Composition of gas barrier layer | |
|---|---|---|---|---|---|---|---|---|
| | | Layer configuration | Dry film thickness (nm) | Oxygen concentration (vol%) | Sample stage temperature (°C) | Integrated irradiation energy (mJ/cm$^2$) | Thickness of region (nm) | Thickness of region (nm) |
| 1 | (A) | First layer | 150 | 0.1 | 80 | 2000 | 5 | 45 |
| | | Second layer | 60 | 0.1 | 80 | 2000 | | |
| 2 | (A) | First layer | 150 | 0.1 | 100 | 2000 | 5 | 80 |
| | | Second layer | 100 | 0.1 | 100 | 2000 | | |
| 3 | (A) | First layer | 150 | 0.5 | 80 | 4000 | 15 | 85 |
| | | Second layer | 100 | 0.1 | 80 | 2000 | | |
| 3 | (A) | First layer | 150 | 2 | 80 | 4000 | 25 | 45 |
| | | Second layer | 60 | 0.1 | 80 | 2000 | | |
| 5 | (A) | First layer | 150 | 2 | 80 | 4000 | 25 | 85 |
| | | Second layer | 100 | 0.1 | 80 | 2000 | | |
| 6 | (A) | First layer | 150 | 0.1 | 80 | 2000 | 25 | 85 |
| | | Second layer | 20 | 1 | 80 | 2000 | | |
| | | Third layer | 100 | 0.1 | 80 | 2000 | | |
| 7 | (A) | First layer | 150 | 0.1 | 100 | 1500 | 45 | 85 |
| | | Second layer | 20 | 0.1 | 100 | 1500 | | |
| | | Third layer | 20 | 0.1 | 100 | 1500 | | |
| | | Fourth layer | 100 | 0.1 | 100 | 2000 | | |
| 8 | (A) | First layer | 150 | 0.1 | 100 | 1500 | 45 | 130 |
| | | Second layer | 20 | 1 | 100 | 1500 | | |
| | | Third layer | 20 | 1 | 100 | 1500 | | |
| | | Fourth layer | 150 | 0.1 | 100 | 1500 | | |

(continued)

| Gas barrier film No. | Type of substrate | Conditions for coating of gas barrier layer and vacuum ultraviolet ray irradiation process | | | | | Composition of gas barrier layer | |
|---|---|---|---|---|---|---|---|---|
| | | Layer configuration | Dry film thickness (nm) | Oxygen concentration (vol%) | Sample stage temperature (°C) | Integrated irradiation energy ($mJ/cm^2$) | Thickness of region (nm) | Thickness of region (nm) |
| 9 | (A) | First layer | 150 | 0.1 | 25 | 1500 | 65 | 280 |
| | | Second layer | 20 | 0.5 | 25 | 1500 | | |
| | | Third layer | 20 | 0.5 | 25 | 1500 | | |
| | | Fourth layer | 20 | 0.5 | 25 | 1500 | | |
| | | Fifth layer | 300 | 0.1 | 25 | 1500 | | |
| 10 | (B) | First layer | 150 | 0.1 | 80 | 2000 | 25 | 85 |
| | | Second layer | 20 | 1 | 80 | 2000 | | |
| | | Third layer | 100 | 0.1 | 80 | 2000 | | |
| 11 | (C) | First layer | 150 | 0.1 | 25 | 1500 | 65 | 280 |
| | | Second layer | 20 | 0.5 | 25 | 1500 | | |
| | | Third layer | 20 | 0.5 | 25 | 1500 | | |
| | | Fourth layer | 20 | 0.5 | 25 | 1500 | | |
| | | Fifth layer | 300 | 0.1 | 25 | 1500 | | |
| 12 | (A) | - | - | - | - | - | 0 | 10 |
| 13 | (A) | - | - | - | - | | 0 | 180 |

«Measurement of composition of gas barrier film»

Thicknesswise composition distribution of the gas barrier layer was measured for the gas barrier films 1 to 13 prepared from above by the method using XPS analysis. At that time, the thicknesswise calibration was performed as described above.

«Condition for XPS analysis»

· Apparatus: QUANTERASXM manufactured by ULVAC-PHI, INCORPORATED.
· X ray source: monochromatized Al-K$\alpha$
· Measurement range: Si2p, C1s, N1s, O1s
· Sputter ion: Ar (2 keV)
· Depth profile: measurement is repeated after sputtering for 1 minute
* It corresponds to thickness of about 5 nm in terms of etching rate converted to $SiO_2$
· Quantification: background is obtained by Shirley method, and quantification is made from an obtained peak area using relative sensitivity coefficient method. For data processing, MultiPak manufactured by ULVAC-PHI, INCORPORATED was used.

According to the XPS analysis, placement position and continuous thickness were measured for the SiOwNx region and the SiOyNz region.

(1) Placement position and continuous thickness of SiOwNx region of the present invention.
* When there are plural SiOwNx regions, it was determined as the thickness of the region having the maximum thickness.
(2) Placement position and continuous thickness of SiOyNz region of the present invention.
* When there are plural SiOyNz regions, it was determined as the thickness of the region having the maximum thickness.

Each measurement result obtained from above is shown in Table 1.

«Evaluation 1: Evaluation of water vapor barrier property»

(Apparatus for preparation of sample for evaluation of water vapor barrier property)

Deposition apparatus: Vacuum deposition apparatus JEE-400 manufactured by JEOL, Ltd.
Constant temperature and humidity oven: Yamato Humidic Chamber IG 47 M manufactured by Yamato Scientific Co., Ltd. (Raw material)

Metal to be corroded by reaction with moisture: calcium (particle)
Water vapor impermeable metal: aluminum ($\varphi$: 3 to 5 mm, particle)

(Preparation of sample for evaluation of water vapor barrier property)

A gas barrier layer surface of the manufactured barrier film sample was vapor-deposited with metal calcium to have a size of 12 mm x 12 mm by passing through a mask using a vacuum deposition apparatus (JEE-400 made by JEOL, Ltd.). At that time, vapor-deposited film thickness was adjusted to 80 nm.

Thereafter, the mask was removed while keeping the vacuum condition, and aluminum was deposited on a whole one surface of the sheet to have vapor-deposited film thickness of 1000 nm for pseudo-sealing. Subsequently, the vacuum condition was removed. After immediate transfer to a dry nitrogen gas atmosphere, a quartz glass having a thickness of 0.2 mmwas adhered onto the aluminum vapor-deposited surface using an ultraviolet curing resin for sealing (manufactured by Nagase ChemteX Co., Ltd.), and ultraviolet rays were irradiated for adhesion and curing of the resin formain sealing. As a result, a sample for evaluating water vapor barrier property was prepared.

The obtained sample was stored in a constant temperature and constant humidity oven at high temperature and high humidity condition of 85°C and 90%RH for 20 hours, 40 hours, and 60 hours, respectively. Then, area of

corroded metal calcium compared to the 12 mm x 12 mm metal calcium deposited-area was calculated and expressed as %. The water vapor barrier property was evaluated according to the following criteria.

○: Area with corroded metal calcium is less than 1.0%.
Δ: Area with corroded metal calcium is the same or higher than 1.0% but less than 5.0%.
× : Area with corroded metal calcium is the same or more than 5.0%.

«Evaluation 2: Evaluation of flexibility»

Each gas barrier film was subjected to 100 times of reciprocal bending treatment which corresponds to 20 mmϕ. At that time, the gas barrier layer surface of the gas barrier film was kept from being in contact with the member. Subsequently, in the same manner as the above evaluation for water vapor barrier property as Evaluation 1, evaluation of the water vapor barrier property was performed.

«Evaluation 3: Evaluation of transparency»

Each gas barrier film was subjected to evaluation of transparencywith a naked eye. The level showing no coloration was labeled ○, the level showing slight coloration was labeled Δ, and the level showing clear coloration was labeled ×.

The evaluation results are given in Table 2.

[Table 2]

| Gas barrier film No. | Water vapor barrier property | | | Flexibility | | | Transparency | Remarks |
|---|---|---|---|---|---|---|---|---|
| | 20 hours | 40 hours | 60 hours | 20 hours | 40 hours | 60 hours | | |
| 1 | × | × | × | × | × | × | ○ | Comparative example |
| 2 | Δ | × | × | Δ | × | × | ○ | Comparative example |
| 3 | Δ | × | × | Δ | × | × | ○ | Comparative example |
| 4 | Δ | × | × | Δ | × | × | ○ | Comparative example |
| 5 | ○ | Δ | × | ○ | Δ | × | ○ | Present invention |
| 6 | ○ | Δ | × | ○ | Δ | × | ○ | Present invention |
| 7 | ○ | ○ | Δ | ○ | ○ | Δ | ○ | Present invention |
| 8 | ○ | ○ | ○ | ○ | ○ | ○ | ○ | Present invention |
| 9 | ○ | ○ | ○ | ○ | ○ | ○ | ○ | Present invention |
| 10 | ○ | Δ | × | ○ | Δ | × | ○ | Present invention |
| 11 | ○ | ○ | ○ | ○ | ○ | ○ | ○ | Present invention |
| 12 | Δ | × | × | Δ | × | × | Δ | Comparative example |
| 13 | Δ | × | × | × | × | × | ○ | Comparative example |

As shown in Table 2, it was found that the gas barrier filmof the present invention has amuch higher barrier property and flexibility than the comparative example.

«Evaluation 4: Evaluation of heat resistance of gas barrier film»

The gas barrier films 10 and 11 prepared above were subjected to a heating treatment under an air atmosphere for 10 min at 220°C. At that time, the gas barrier layer surface of the gas barrier film was kept from being in contact with the member. After the heating treatment, it was extracted into an atmosphere at room temperature and cooled to room temperature as it is. Subsequently, in the same manner as the evaluation of water vapor barrier property as Evaluation 1, evaluation of the water vapor barrier property was performed. The results were also good like those without having heating treatment. Accordingly, it was found that the gas barrier film of the present invention has excellent heat resistance and a very high barrier property.

Example 2

«Manufacture of organic thin layer electronic device»

By using the gas barrier films 1 to 13 produced in Example 1 as a sealing film, each of the organic EL elements 1 to 13 as an organic thin layer electronic device was fabricated.

[Manufacture of organic EL element]

(Formation of first electrode layer)

On the gas barrier layer of each gas barrier film, ITO (indium tin oxide) film with thickness of 150 nm was formed by a sputtering method, and by performing patterning by photolithography, a first electrode layer was formed. Meanwhile, the pattern was formed to be a pattern having a light emitting area of 50 $mm^2$.

(Formation of hole transport layer)

On the top of the first electrode layer of each gas barrier film having the first electrode layer formed thereon, a coating liquid for forming a hole transport layer was coated using an extrusion coater, and a hole transport layer was formed by drying. The coating liquid for forming a hole transport layer was coated such that the thickness after drying is 50 nm.

Before applying the coating liquid for forming a hole transport layer, a treatment for modifying a cleaned surface of the gas barrier film was performed at irradiation intensity of 15 $mW/cm^2$ and distance of 10 mm by using a low pressure mercury lamp with wavelength of 184.9 nm. The antistatic treatment was performed by using a neutralizer having weak X ray.

<Coating condition>

The coating process was performed under the air environment of 25°C and relative humidity of 50%.

<Preparation of coating liquid for forming hole transport layer>

A solution obtained by diluting polyethylene dioxythiophene · polystyrene sulfonate (PEDOT/PSS, Baytron P AI 4083 manufactured by Bayer) with to 65% with pure water, 5% with methanol was prepared as a coating liquid for forming a hole transport layer.

<Condition for drying and heating treatment>

After applying the coating liquid for forming a hole transport layer, the solvent was removed at temperature of 100°C with air from height of 100 mm, discharge air speed of 1 m/s, and width air speed distribution of 5% toward the formed film surface. Subsequently, by using an apparatus for heating treatment, a heating treatment based on backside electric heating mode was performed at 150°C to form a hole transport layer.

(Formation of light emitting layer)

Subsequently, on the top of the hole transport layer of each gas barrier film having up to a hole transport layer formed thereon, a coating liquid for forming a white light emitting layer shown below was coated by using an extrusion coater, and an light emitting layer was formed by drying. The coating liquid for forming a white light emitting layer was coated such that the thickness after drying is 40 nm.

<Coating liquid for forming white light emitting layer>

1.0 g of the host material H-A, 100 mg of the dopant material D-A, 0.2 mg of the dopant material D-B, and 0.2 mg of the dopant material D-C were dissolved in 100 g toluene to prepare a coating liquid for forming a white light emitting layer. Meanwhile, each of the host material H-A, the dopant material D-A, the dopant material D-B, and the dopant material D-C has the structure shown below.

[Chem. 2]

H-A

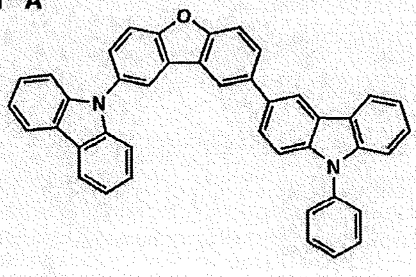

D-A

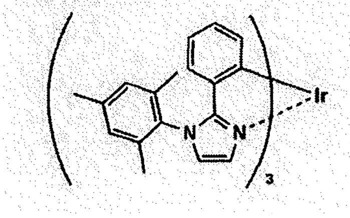

D-B

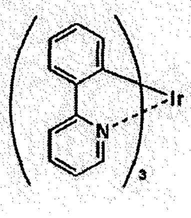

D-C

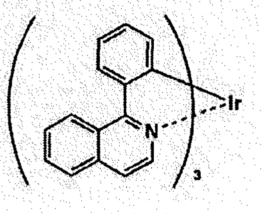

<Coating condition>

The coating process was performed under an environment with nitrogen gas concentration of 99% or more, temperature of 25°C and coating speed of 1 m/min.

<Condition for drying and heating treatment>

After applying the coating liquid for forming a white light emitting layer, the solvent was removed at temperature of 60°C with air from height of 100 mm, discharge air speed of 1 m/s, and width air speed distribution of 5% toward the formed film surface. Subsequently, according to a heating treatment at the temperature of 130°C, a light emitting layer was formed.

(Formation of electron transport layer)

Subsequently, after forming the light emitting layer, the following coating liquid for forming an electron transport layer was coated using an extrusion coater, and an electron transport layer was formed by drying. The coating liquid for forming an electron transport layer was coated such that the thickness after drying is 30 nm.

<Coating condition>

The coating process was performed under an environment with nitrogen gas concentration of 99% ormore, and temperature of 25°C and coating speed of 1 m/min for the coating liquid for forming an electron transport layer.

<Coating liquid for forming electron transport layer>

As for the electron transport layer, the E-A was dissolved in 2,2,3,3-tetrafluoro-1-propanol to obtain a 0.5% by weight solution, which was then used as a coating liquid for forming an electron transport layer.

[Chem. 3]

E-A

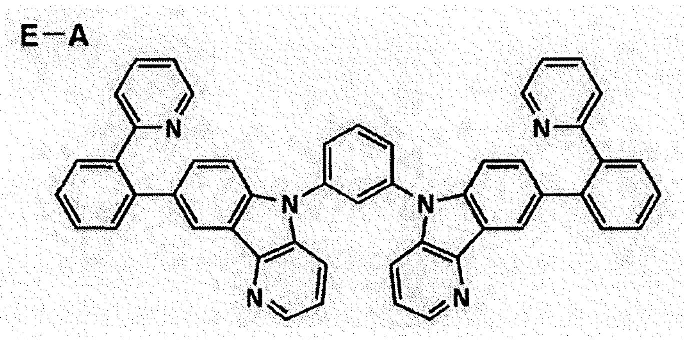

<Condition for drying and heating treatment>

After applying the coating liquid for forming an electron transport layer, the solvent was removed at temperature of 60°C with air from height of 100 mm, discharge air speed of 1 m/s, and width air speed distribution of 5% toward the formed film surface. Subsequently, according to a heating treatment at the temperature of 200°C in a heating treatment part, an electron transport layer was formed.

(Formation of electron injection layer)

Subsequently, an electron injection layer was formed on the top of the formed electron transport layer. First, the substrate was added into a chamber under reduced pressure, and the pressure was lowered to $5 \times 10^{-4}$ Pa. By heating cesium fluoride which has been prepared in advance in a tantalum deposition boat within a vacuum chamber, an electron injection layer having a thickness of 3 nm was formed.

(Formation of second electrode)

Subsequently, on the formed electron injection layer, a mask pattern film was formed to have a light emitting area of 50 $mm^2$ by using aluminum as a material for forming a second electrode under vacuum of $5 \times 10^{-4}$ Pa and vapor deposition method to have an extraction electrode, and as a result, the second electrode having a thickness of 100 nm was laminated.

(Cutting)

Each gas barrier film formed up to the second electrode was transferred again to a nitrogen atmosphere, and cut to a pre-determined size by using ultraviolet laser to manufacture an organic EL element.

(Attachment of electrode lead)

To the manufactured organic EL element, a flexible print substrate (base film: polyimide 12.5 μm, pressed copper foil 18 μm, cover layer: polyimide 12.5 μm, surface treatment: NiAu plating) was attached by using an anisotropic conductive film DP3232S9 manufactured by Sony Chemical and Information Device Corporation.

Compression condition: compression was performed for 10 seconds at temperature of 170°C (ACF temperature of 140°C measured by using a separate thermocouple) and pressure of 2 MPa.

(Sealing)

The organic EL element attached with an electrode lead (flexible print substrate) was attached with a sealing member by using a commercially available roll lamination apparatus to manufacture organic EL elements 1 to 13.
Meanwhile, as a sealing member, a 30-μm thick aluminumfoil (manufacturedbyTOYOALUMINIUMK.K.) laminated with a polyethylene terephthalate (PET) film (12-μm thick) by using adhesive for dry lamination (two-liquid reaction type urethane-based adhesive) was used (thickness of adhesive layer: 1.5 μm).
A thermosetting adhesive was uniformly coated on an aluminum surface to have a thickness of 20 μm along the surface attached with an aluminum foil (glossy surface) by using a dispenser.
As the thermosetting adhesive, the following epoxy-based adhesive was used.

Bisphenol A diglycidyl ether (DGEBA) Dicyandiamide (DICY)

Epoxy adduct-based curing promoter

After that, the sealed substrate was closely attached and placed such that the connection part between the extraction electrode and the electrode lead is covered. Then, it was tightly sealed by using a compression roll with compression condition including compression roll temperature of 120°C, pressure of 0.5 MPa, and apparatus speed of 0.3 m/min.

«Evaluation of organic EL element»

The organic EL elements 1 to 13 manufactured above were subjected to durability evaluation according to the method described below.

[Durability evaluation]

(Accelerated deterioration treatment)

Each organic EL element manufactured above was subj ected to an accelerated deterioration treatment for 400 hours under atmosphere of 60°C and 90%RH. Thereafter, together with an organic EL element not treated with an accelerated deterioration treatment, durability was evaluated by performing an evaluation of dark spots.

(Evaluation of dark spots)

Each of the organic EL element after the accelerated deterioration treatment and the organic EL element not treated with the accelerated deterioration treatment was applied with electric current of 1 mA/cm$^2$. After continuous light emission for 24 hours, a part of the panel was enlarged by using 100x microscope (MS-804 manufactured by MORITEX CORPORATION, lens: MP-ZE25-200), and a photographic image was taken. After cutting the photographed image to a 2-mm square, the ratio of an area having dark spots was obtained and the ratio of resistance to element deterioration was calculated according to the following formula. The durability was then evaluated according to the following criteria. When the evaluated rank is ◎ or ○, it was determined as a practically preferable one.

Resistance to element deterioration = (Area of dark spots occurred in an element not treated with accelerated deterioration treatment/Area of dark spots occurred in an element treated with accelerated deterioration treatment) × 100 (%)

◎ : Resistance to element deterioration is 90% or higher.
○ : Resistance to element deterioration is 60% or higher but lower than 90%.

Δ : Resistance to element deterioration is 20% or higher but lower than 60%.
× : Resistance to element deterioration is lower than 20%.

The results obtained from above are described in Table 3.

[Table 3]

| Organic EL element No. | Gas barrier film No. | Durability | Remark |
|---|---|---|---|
| 1 | 1 | × | Comparative example |
| 2 | 2 | × | Comparative example |
| 3 | 3 | × | Comparative example |
| 4 | 4 | × | Comparative example |
| 5 | 5 | ○ | Present invention |
| 6 | 6 | ○ | Present invention |
| 7 | 7 | ◎ | Present invention |
| 8 | 8 | ◎ | Present invention |
| 9 | 9 | ◎ | Present invention |
| 10 | 10 | ○ | Present invention |
| 11 | 11 | ◎ | Present invention |
| 12 | 12 | × | Comparative example |
| 13 | 13 | × | Comparative example |

As clearly shown in the results described in Table 3, the gas barrier film of the present invention has very high durability enabling use as a sealing film of an organic EL element.
The present application is based on Japanese Patent Application No. 2011-141490 filed on June 27, 2011, and its disclosure is incorporated herein by reference in its entirety.

## Claims

1. A gas barrier film comprising at least two gas barrier layers which comprise at least Si, O, and N and are laminated on a substrate, wherein the total thicknesswise composition distribution of the gas barrier layers comprises both a thicknesswise continuous region which has a thickness of 20 nm or more and satisfies the following composition range (A) and a thicknesswise continuous region which has a thickness of 50 nm or more and satisfies the following composition range (B) in this order from the substrate side:

   (A): When the composition of the gas barrier layer is represented by $SiO_wN_x$, $w \geq 0.8$, $x \geq 0.3$, and $2w + 3x \leq 4$.
   (B): When the composition of the gas barrier layer is represented by $SiO_yN_z$, $0 < y \leq 0.55$ and $z \geq 0.55$, and $2y + 3z \leq 4$.

2. The gas barrier film according to claim 1, wherein the thicknesswise continuous region satisfying the composition range (A) is 40 nm to 100 nm.

3. The gas barrier film according to claim 1 or 2, wherein the thicknesswise continuous region satisfying the composition range (B) is 100 nm to 1.0 μm.

4. The gas barrier film according to any one of claims 1 to 3, wherein the gas barrier layer is a layer formed by irradiating a layer comprising polysilazane with vacuum ultraviolet ray.

5. An electronic device using the gas barrier film according to any one of claims 1 to 4.

6. Amethod for manufacturing the gas barrier film according to any one of claims 1 to 4, the method comprising forming

the gas barrier layer by performing irradiation of vacuum ultraviolet ray on a layer formed by applying a solution comprising polysilazane.

FIG. 1

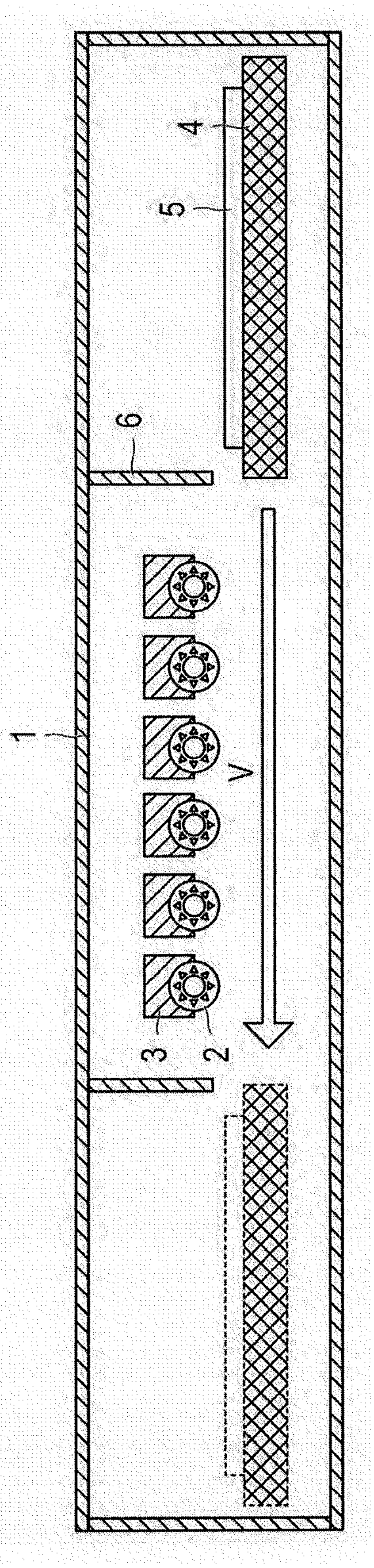

## INTERNATIONAL SEARCH REPORT

International application No.
PCT/JP2012/065097

A. CLASSIFICATION OF SUBJECT MATTER
*B32B9/00*(2006.01)i, *B05D1/38*(2006.01)i, *B05D3/06*(2006.01)i, *B05D7/24*(2006.01)i, *B32B5/14*(2006.01)i, *B32B27/00*(2006.01)i, *B32B27/16*(2006.01)i, *H01L51/50*(2006.01)i, *H05B33/04*(2006.01)i

According to International Patent Classification (IPC) or to both national classification and IPC

B. FIELDS SEARCHED

Minimum documentation searched (classification system followed by classification symbols)
B32B1/00-43/00, B05D1/00-7/26, H01L51/00-51/56, H05B33/00-33/28

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2012 |
| Kokai Jitsuyo Shinan Koho | 1971-2012 | Toroku Jitsuyo Shinan Koho | 1994-2012 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| A | JP 2009-255040 A (Kyodo Printing Co., Ltd.), 05 November 2009 (05.11.2009), claims; examples; drawings (Family: none) | 1-6 |
| A | WO 2011/027619 A1 (Konica Minolta Holdings, Inc.), 10 March 2011 (10.03.2011), claims; examples (Family: none) | 1-6 |
| P,A | JP 2011-173057 A (Konica Minolta Holdings, Inc.), 08 September 2011 (08.09.2011), claims; examples; drawings (Family: none) | 1-6 |

☒ Further documents are listed in the continuation of Box C.    ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| | |
|---|---|
| Date of the actual completion of the international search<br>27 August, 2012 (27.08.12) | Date of mailing of the international search report<br>04 September, 2012 (04.09.12) |
| Name and mailing address of the ISA/<br>Japanese Patent Office<br>Facsimile No. | Authorized officer<br><br>Telephone No. |

Form PCT/ISA/210 (second sheet) (July 2009)

**INTERNATIONAL SEARCH REPORT**

International application No.
PCT/JP2012/065097

C (Continuation). DOCUMENTS CONSIDERED TO BE RELEVANT

| Category* | Citation of document, with indication, where appropriate, of the relevant passages | Relevant to claim No. |
|---|---|---|
| P,A | JP 2011-183773 A (Konica Minolta Holdings, Inc.), 22 September 2011 (22.09.2011), claims; examples; drawings (Family: none) | 1-6 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2002322561 A
- JP 2003206361 A
- JP 2004314626 A
- US 20060226517 A
- JP 2008142941 A
- JP 8112879 A
- JP 5238827 A
- JP 6122852 A
- JP 6240208 A
- JP 6299118 A
- JP 6306329 A
- JP 7196986 A
- JP 2007017948 A
- WO 0316599 A
- WO 0328125 A
- US 6690029 B
- JP 2004107216 A
- US 2003136964 A
- WO 2008000664 A
- JP 2008016834 A
- JP 2006199674 A
- JP 2008130889 A
- US 7329709 B
- WO 0619270 A
- JP 5271166 A
- JP 2006233252 A
- JP 2002266007 A
- JP 2004149871 A
- JP 2011141490 A


### Non-patent literature cited in the description


- *Leibniz Institute of Surface Modification Biannual Report,* 2008, 18, 21
- *J. Amer. Chem. Soc.,* vol. 127 (14), 4986
- *J. Amer. Chem. Soc.,* vol. 123, 9482
- *J. Amer. Chem. Soc.,* 2008, vol. 130 (9), 2706
- *Technical Digest of the International PVSEC-17, Fukuoka, Japan,* 2007, 1225
- *Nature Material,* 2006, vol. 5, 328
- *Adv. Mat.,* 2007, 4160
- *Nature Material,* 2007, vol. 6, 497
- *Adv. Mater,* 2008, vol. 20, 2116
- *Adv. Mater.,* 2002, vol. 14, 833-837
- *Chem. Mater.,* 2002, vol. 14, 4736-4745